(19) Europäisches Patentamt
European Patent Office
Office européen des brevets

(11) **EP 3 048 730 B1**

(12) **FASCICULE DE BREVET EUROPEEN**

(45) Date de publication et mention de la délivrance du brevet:
**07.09.2022   Bulletin 2022/36**

(21) Numéro de dépôt: **16152476.4**

(22) Date de dépôt: **22.01.2016**

(51) Classification Internationale des Brevets (IPC):
*H03L 7/085* (2006.01)        *H03L 7/18* (2006.01)

(52) Classification Coopérative des Brevets (CPC):
**H03L 7/085; H03L 7/1806**

(54) **DISPOSITIF DE SYNTHÈSE DE FRÉQUENCE À BOUCLE DE RÉTROACTION**

VORRICHTUNG ZUR ERZEUGUNG EINER RÜCKKOPPLUNGSSCHLEIFENFREQUENZ

FREQUENCY SYNTHESIS DEVICE WITH FEEDBACK LOOP

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **23.01.2015   FR 1550560**

(43) Date de publication de la demande:
**27.07.2016   Bulletin 2016/30**

(73) Titulaire: **Commissariat à l'Énergie Atomique et aux Énergies Alternatives
75015 Paris (FR)**

(72) Inventeur: **LACHARTRE, David
38330 Montbonnot (FR)**

(74) Mandataire: **Bonnet, Michel
Cabinet Bonnet
93, rue Réaumur - Boîte 10
75002 Paris (FR)**

(56) Documents cités:
**WO-A1-2004/001974        FR-A1- 2 908 946
GB-A- 2 451 475        US-A1- 2002 125 957
US-A1- 2006 020 649        US-A1- 2008 024 240**

• **THURIES S ET AL: "A 3-bits DDS Oriented Low Power Consumption 15 GHz Phase Accumulator in a 0.25 Î1?4m BiCMOS SiGe:C Technology", ELECTRONICS, CIRCUITS AND SYSTEMS, 2006. ICECS '06. 13TH IEEE INTERNAT IONAL CONFERENCE ON, IEEE, PI, 10 December 2006 (2006-12-10), pages 991-994, XP031636139, ISBN: 978-1-4244-0394-3**

## Description

La présente invention concerne un dispositif de synthèse de fréquence à boucle de rétroaction.

On connaît de tels dispositifs, par exemple des boucles à phase asservie dites PLL (de l'Anglais « Phase Locked Loop »), généralement appelée boucles à verrouillage de phase.

Un dispositif de ce type comporte :

- une entrée destinée à recevoir un signal électrique oscillant à une fréquence de référence,
- une sortie destinée à fournir un signal électrique oscillant à une fréquence de sortie,
- un circuit d'asservissement de la fréquence de sortie à la fréquence de référence, reliant l'entrée à la sortie du dispositif et comportant un comparateur de phases, un filtre de boucle et un oscillateur à fréquence contrôlée fournissant le signal électrique oscillant à la fréquence de sortie, et
- une boucle de rétroaction reliant la sortie à l'une de deux entrées de comparaison du comparateur de phases.

L'oscillateur à fréquence contrôlée, par exemple de type VCO (de l'anglais « Voltage Controlled Oscillator »), DCO (de l'anglais « Digitally Controlled Oscillator ») ou autre, est commandé par une valeur numérique, une tension ou un courant analogique, voire une combinaison d'une valeur analogique et d'une valeur numérique. Bien que ce ne soit en général pas le cas, la fonction de transfert d'un tel oscillateur est souvent considérée comme linéaire et simplement représentée par un facteur de conversion K.

Le comparateur de phases fonctionne en général sur les fronts de deux signaux à comparer, c'est-à-dire lorsque ces signaux atteignent une même valeur à même pente. Le comparateur de phases fournit alors lui-même un ou plusieurs signaux qui représentent la différence de phase entre les fronts des deux signaux comparés. La plupart du temps, les signaux résultants de la comparaison sont transformés en un seul signal d'impulsion de courant ou de tension par une pompe de charge (de l'anglais « charge pump »). Ce courant (ou tension) est d'amplitude I (ou U) constante, il prend le signe de la différence de phase et son impulsion possède une largeur proportionnelle à la différence de phase. Le comparateur de phases peut être réalisé de façon plus ou moins analogique ou numérique.

L'impulsion fournie par la pompe de charge est ensuite filtrée par le filtre de boucle qui a pour base la réponse impulsionnelle d'un filtre intégrateur. Le filtre de boucle peut lui aussi être réalisé de façon plus ou moins analogique ou numérique.

Le résultat issu du filtre de boucle est alors appliqué comme commande de l'oscillateur à fréquence contrôlée. Comme le filtre de boucle est intégrateur et que l'intégrale de la phase d'un signal périodique donne sa fréquence, la commande de l'oscillateur est bien proportionnelle à une fréquence qui va tendre vers la fréquence désirée en sortie au fur et à mesure que la différence de phase avec le signal de référence va tendre vers 0 ou vers une autre valeur constante.

Les PLL sont ainsi généralement utilisées dans les circuits électroniques en tant que sources de fréquences élevées. En effet, ces dispositifs permettent à partir d'une source à basse fréquence et de haute pureté spectrale (par exemple du quartz émettant des signaux périodiques à quelques MHz) d'obtenir des signaux périodiques à haute fréquence (par exemple quelques GHz) et avec une pureté spectrale de meilleure qualité que les dispositifs générant directement des signaux à haute fréquence.

Concrètement, pour une source de fréquence de référence basse et de haute pureté spectrale $F_{ref}$, on obtient en sortie un signal de bonne pureté spectrale à haute fréquence $F_c = \alpha.F_{ref}$, $\alpha$ étant un facteur multiplicatif choisi supérieur à 1. Ce facteur multiplicatif $\alpha$ est généralement variable et de valeur réelle non entière afin de faire varier les différents canaux des normes utilisées suivant l'application.

Un paramètre important des dispositifs de synthèse de fréquence est le temps $\Delta t$ d'établissement de leur régime de fonctionnement, c'est-à-dire le temps qu'ils mettent à être fonctionnels, soit au démarrage, soit lors d'un changement de canal (i.e. changement du facteur a). Ce temps $\Delta t$ perdure pendant un régime transitoire, généralement qualifié de phase d'accrochage, précédant le régime de fonctionnement. Ainsi par exemple, lors du passage $\Delta F_c$ d'une fréquence $F_c$ à une fréquence $F'_c$, le régime transitoire de fréquence synthétisée suit une enveloppe exponentielle tendant asymptotiquement vers $F'_c$ à une fréquence de résonance propre $\omega$ pendant la durée $\Delta t$. La durée $\Delta t$ de la phase d'accrochage dépend des paramètres constitutifs d'un dispositif de synthèse de fréquence et limite sa réactivité.

Un autre paramètre important des dispositifs de synthèse de fréquence est la résolution des variations possibles du facteur multiplicatif $\alpha$ et donc la finesse de réglage possible de la fréquence de sortie $F_c$ en fonction des applications ou normes visées.

D'autres paramètres à considérer, pour optimiser les dispositifs de synthèse de fréquence et la qualité des signaux périodiques de fréquence $F_c$ obtenus en sortie, incluent le bruit de phase, la gigue (de l'anglais « jitter »), les signaux parasites (de l'anglais « spurious signais ») et la consommation électrique.

Selon une conception bien connue des PLL, dite à division entière, le facteur multiplicatif $\alpha$ est choisi comme le quotient de deux valeurs entières N et D où la valeur N est généralement supérieure à D. Pour parvenir à cet asservissement $F_c = \alpha.F_{ref} = N/D.F_{ref}$, un diviseur de fréquence de facteur D est disposé dans le circuit d'asservissement entre l'entrée et une première entrée de comparaison du comparateur de phases, tandis qu'un diviseur de fréquence de facteur N est disposé dans la boucle de rétroaction entre la sortie, qui correspond à la sortie de l'oscillateur à fréquence contrôlée, et une deuxième entrée de comparaison du comparateur de phases. De la sorte, la fréquence des deux signaux comparés par le comparateur de phases est destinée à converger vers $F_{ref}/D = F_c/N$ lorsque la boucle est verrouillée. Ainsi, en sortie du comparateur de phases, bien que filtrée par le filtre de boucle, cette fréquence $F_{ref}/D$ se retrouve au niveau de la commande de l'oscillateur à fréquence contrôlée et donc en tant que parasite dans le spectre du signal de sortie. Par ailleurs, il est clair que la valeur de D est directement corrélée à la résolution des variations possibles du facteur multiplicatif $\alpha$ puisque ces variations se font, pour différentes valeurs de N possibles, par pas fréquentiels de $F_{ref}/D$.

Il en résulte que pour augmenter la résolution des variations possibles du facteur multiplicatif a, il conviendrait d'augmenter la valeur de D. Mais dans ce cas, la fréquence $F_{ref}/D$ serait réduite et il conviendrait alors de réduire également la bande passante du filtre de boucle pour limiter les parasites résultants dans le spectre du signal de sortie. Or limiter la bande passante du filtre de boucle conduit à allonger le temps $\Delta t$ d'établissement du régime de fonctionnement. Par conséquent, optimiser conjointement les deux paramètres importants d'une PLL, que constituent le temps d'établissement du régime de fonctionnement et la résolution des variations possibles du facteur multiplicatif a, est impossible à réaliser avec une PLL à division entière.

Par ailleurs, les contributions au bruit de phase induit en sortie dépendent directement elles aussi de la fréquence de coupure de la PLL. Dans la bande passante, le bruit est dominé par la contribution du signal de référence. Bien que multiplié par a, il reste en général moindre que celui apporté par la PLL elle-même. Il peut ainsi être préférable de monter la fréquence de coupure de la PLL afin d'abaisser le bruit de phase dans la partie basse du spectre obtenu en sortie. Mais dans ce cas, c'est au détriment de la valeur de D. Par conséquent, optimiser conjointement le bruit de phase et la résolution des variations possibles du facteur multiplicatif a, est impossible à réaliser avec une PLL à division entière.

Une solution partielle à ces inconvénients consiste à concevoir une PLL à pas fractionnaires comme enseigné dans la demande de brevet FR 2 763 196 A1. Dans ce cas, le diviseur de fréquence disposé dans la boucle de rétroaction commute entre le facteur N et le facteur N+1 selon une proportion souhaitée prédéterminée, de manière à produire en moyenne, grâce au filtre de boucle, un facteur multiplicatif $\alpha = (N+\beta)/D$, avec $0 \leq \beta \leq 1$. Ainsi, sans augmenter la valeur de D, il devient possible d'augmenter la résolution des variations possibles du facteur multiplicatif a.

Cependant, pour réaliser cette commutation du diviseur de la boucle de rétroaction entre les deux valeurs N et N+1 selon une proportion souhaitée, un modulateur Delta-Sigma est généralement utilisé. Ce modulateur a la particularité de générer un signal résultant d'une quantification du coefficient $\beta$ sur 1 bit et la quantification produit nécessairement une erreur de quantification qui, dans le cas du modulateur Delta-Sigma, n'est pas répartie uniformément dans le spectre de sortie mais est amplifiée dans les hautes fréquences. Le filtre de boucle atténue donc partiellement le bruit résultant de cette erreur. Néanmoins, une PLL à pas fractionnaires produit un signal qui reste plus ou moins entaché d'un bruit supplémentaire dû à la génération du coefficient $\beta$. D'ailleurs plus $\beta$ aura besoin de précision (i.e. pour une meilleure résolution à N et D constants), plus ce bruit supplémentaire sera important.

De plus, une PLL à pas fractionnaire n'optimise pas non plus le bruit de phase indépendamment du facteur multiplicatif a, la fréquence de fonctionnement du comparateur de phases restant dépendante de ce facteur.

Une autre solution consiste à ne pas utiliser de diviseurs de fréquences mais des accumulateurs de phases, comme enseigné par exemple dans les demandes de brevets US 2011/0133795 A1 et WO 2009/053531 A1, ou dans l'article de Staszewski et al, intitulé « Phase-domain all-digital phase-locked loop », publié en mars 2005 dans IEEE Transactions on Circuits and Systems-II: express briefs, vol. 52, n° 3, pages 159-163, de manière à calculer numériquement des accumulations de phases à partir de chacun des signaux de référence et de sortie plutôt que de réaliser une comparaison de phases sur des signaux issus de diviseurs. Cette autre solution est en particulier bien adaptée à la conception de PLL dites « entièrement numériques ».

Conformément à cette autre solution, l'invention concerne plus précisément un dispositif de synthèse de fréquence à boucle de rétroaction comportant :

- une entrée destinée à recevoir un signal électrique oscillant à une fréquence de référence,
- une sortie destinée à fournir un signal électrique oscillant à une fréquence de sortie,
- un circuit d'asservissement de la fréquence de sortie à la fréquence de référence, reliant l'entrée à la sortie du dispositif et comportant un premier accumulateur de phase cadencé à une fréquence liée à la fréquence de référence, un comparateur de phases, un filtre de boucle et un oscillateur à fréquence contrôlée fournissant le signal électrique oscillant à la fréquence de sortie, et
- une boucle de rétroaction reliant la sortie à l'une de deux entrées de comparaison du comparateur de phases, comportant un deuxième accumulateur de phase cadencé à une fréquence liée à la fréquence de sortie.

Ainsi, pour une PLL à division entière de facteur multiplicatif $\alpha = N/D$, le premier accumulateur de phase peut par exemple être associé à une valeur d'incrément de phase égale à N et le deuxième à une valeur d'incrément de phase égale à D.

Il résulte de cette autre solution que la fréquence de fonctionnement du comparateur de phases peut être rendue indépendante du facteur $\alpha$ et donc du choix de D. D peut alors être augmenté dans des proportions bien plus importantes que celles des dispositifs à diviseurs de fréquences, tout en conservant une fréquence de fonctionnement élevée du comparateur de phases, d'où une meilleure résolution sans concession sur le temps $\Delta t$ d'établissement du régime de fonctionnement ou sur le bruit de phase.

Cependant cette autre solution fournit des valeurs numériques en sorties des accumulateurs de phases et celles-ci sont cadencées selon des fréquences différentes. Plus précisément, dans les documents US 2011/0133795 A1, WO 2009/053531 A1 et dans l'article de Staszewski et al précité, la fréquence sur laquelle sont cadencées les valeurs numériques issues du premier accumulateur de phase est $F_{ref}$, tandis que la fréquence sur laquelle sont cadencées les valeurs numériques issues du deuxième accumulateur de phase est $F_c$. Les données fournies au comparateur de phases, qui n'est rien d'autre qu'un soustracteur numérique, ne sont donc pas synchronisées entre elles, ce qui pose un problème. Ce problème est par exemple résolu de façon partielle et non satisfaisante dans WO 2009/053531 A1, ou dans l'article de Staszewski et al précité, en compliquant singulièrement la boucle de rétroaction pour tenter de resynchroniser entre elles les données numériques issues des deux accumulateurs de phases. Cette resynchronisation engendre par ailleurs un bruit supplémentaire.

Une autre solution basée sur la détection de phase utilisant les accumulateurs de phase est décrite par la publication de la demande de brevet WO2004/001974.

Il peut ainsi être souhaité de prévoir un dispositif de synthèse de fréquence à boucle de rétroaction comportant : - une entrée destinée à recevoir un signal électrique oscillant à une fréquence de référence (Fref), - une sortie destinée à fournir un signal électrique oscillant à une fréquence de sortie (Fc), - un circuit d'asservissement de la fréquence de sortie (Fc) à la fréquence de référence (Fref), reliant l'entrée à la sortie du dispositif et comportant un premier accumulateur de phase cadencé à une fréquence liée à la fréquence de référence (Fref), un comparateur analogique de phases, un premier convertisseur numérique/analogique disposé entre le premier accumulateur de phase et le comparateur analogique de phases, un filtre de boucle et un oscillateur à fréquence contrôlée fournissant le signal électrique oscillant à la fréquence de sortie (Fc), et - une boucle de rétroaction reliant la sortie à l'une de deux entrées de comparaison du comparateur analogique de phases, comportant un deuxième accumulateur de phase cadencé à une fréquence liée à la fréquence de sortie (Fc) et un deuxième convertisseur numérique/ analogique disposé entre le deuxième accumulateur de phase et le comparateur analogique de phases, dans lequel : - le premier convertisseur numérique/analogique, respectivement le deuxième convertisseur numérique/analogique, est disposé pour fournir en sortie un signal qui est une représentation analogique en temps continu d'une valeur numérique de phase accumulée (cpref, cpc) qui lui est fournie par le premier accumulateur de phase, respectivement le deuxième accumulateur de phase, - le comparateur analogique de phases est un additionneur ou soustracteur en temps continu des signaux analogiques en temps continu qui lui sont fournis en entrée par les premier et deuxième convertisseurs numérique/analogique, - les premier et deuxième accumulateurs de phases présentent une valeur seuil (Th) commune de phase accumulée au-delà de laquelle il est prévu de soustraire une valeur de modulo (Th) à la valeur de phase accumulée dans chacun des premier et deuxième accumulateurs de phase, et - un mécanisme de synchronisation est prévu pour soustraire la valeur de modulo (Th) dans chacun des premier et deuxième accumulateurs de phases dès lors que la valeur seuil commune (Th) est dépassée dans chacun des premier et deuxième accumulateurs de phase, le mécanisme de synchronisation est conçu pour que cette soustraction de la valeur de modulo (Th) soit réalisée à un même instant de la façon suivante : - le mécanisme de synchronisation est conçu pour que la soustraction de la valeur de modulo (Th) comporte une remise à zéro asynchrone de deux bascules synchrones respectives à sorties binaires de poids le plus fort de deux registres de mémorisation respectifs des premier et deuxième accumulateurs de phases, et - le mécanisme de synchronisation de chacun des premier et deuxième accumulateurs de phases comporte, pour réaliser la soustraction de la valeur de modulo (Th) audit même instant, une porte logique ET recevant la valeur de la sortie binaire de la bascule synchrone de poids le plus fort du registre de mémorisation et un signal indiquant ledit même instant où les premier et deuxième accumulateurs de phases ont dépassé la valeur seuil de manière à forcer à zéro audit même instant le bit de poids le plus fort de la sortie du registre de mémorisation le cas échéant.

Ainsi, non seulement un dispositif de synthèse de fréquence selon l'invention rend la fréquence de fonctionnement du comparateur de phases indépendante du facteur a, mais en outre il résout simplement et efficacement les difficultés de synchronisation que peut engendrer l'utilisation d'accumulateurs de phases. En transformant les signaux numériques issus de ces accumulateurs en des signaux analogiques en temps continu, et en employant un comparateur de phases apte à traiter ces signaux analogiques, on produit analogiquement et en temps continu une valeur de différence de phases pouvant être directement fournie au filtre de boucle.

Le comparateur de phases est un additionneur ou soustracteur en temps continu des signaux analogiques qu'il reçoit en entrée.

Les premier et deuxième accumulateurs de phases présentent une valeur seuil commune de phase accumulée au-delà de laquelle il est prévu de soustraire une valeur de modulo à la valeur de phase accumulée dans chacun des premier et deuxième accumulateurs de phase.

Le mécanisme de synchronisation est prévu pour soustraire la valeur de modulo à un même instant dans chacun des premier et deuxième accumulateurs de phases dès lors que la valeur seuil commune est dépassée dans chacun des premier et deuxième accumulateurs de phase.

De façon optionnelle également, la valeur seuil et la valeur de modulo sont égales.

De façon optionnelle également, un diviseur de fréquence est disposé dans la boucle de rétroaction entre la sortie et le deuxième accumulateur de phase.

De façon optionnelle également, le diviseur de fréquence présente un facteur de division choisi de telle sorte que, pour un facteur d'asservissement souhaité de la fréquence de sortie à la fréquence de référence, le deuxième accumulateur de phase présente une valeur d'incrément de phase qui puisse être aussi proche que possible d'une valeur d'incrément de phase du premier accumulateur de phase tout en restant inférieure ou égale à cette dernière.

De façon optionnelle également, le facteur de division est choisi de telle sorte que la partie entière du logarithme de base deux de la valeur d'incrément de phase du premier accumulateur de phase soit égale à la partie entière du logarithme de base deux de la valeur d'incrément de phase du deuxième accumulateur de phase.

De façon avantageuse, une réduction de dynamique par quantification est prévue entre chaque accumulateur de phase et chaque convertisseur numérique/analogique respectif.

De façon optionnelle également, chaque réduction de dynamique est réalisée par un quantificateur à modulation Delta-Sigma.

L'invention sera mieux comprise à l'aide de la description qui va suivre, donnée uniquement à titre d'exemple et faite en se référant aux dessins annexés dans lesquels :

- la figure 1 représente schématiquement la structure générale d'un dispositif de synthèse de fréquence à boucle de rétroaction,
- la figure 2 est un chronogramme illustrant les évolutions de données numériques obtenues à l'aide du dispositif de la figure 1,
- la figure 3 représente schématiquement la structure générale d'un dispositif de synthèse de fréquence à boucle de rétroaction, comprenant les accumulateurs de phase représentés par la figure 14, selon un deuxième mode de réalisation de l'invention,
- la figure 4 est un diagramme temporel illustrant les évolutions de données numériques obtenues à l'aide du dispositif de la figure 3,
- les figures 5 et 6 sont des spectres à échelles logarithmiques de fréquences illustrant les caractéristiques de signaux obtenus à l'aide du dispositif de la figure 3,
- la figure 7 représente schématiquement la structure générale d'un dispositif de synthèse de fréquence à boucle de rétroaction, comprenant les accumulateurs de phase représentés par la figure 14, selon un troisième mode de réalisation de l'invention,
- la figure 8 représente schématiquement la structure générale d'un dispositif de synthèse de fréquence à boucle de rétroaction, comprenant les accumulateurs de phase représentés par la figure 15, selon un quatrième mode de réalisation de l'invention,
- la figure 9 est un spectre à échelle logarithmique de fréquences illustrant les caractéristiques d'un signal obtenu à l'aide du dispositif de la figure 8,
- les figures 10 et 11 représentent deux exemples de filtres de boucles pour l'un quelconque des dispositifs de synthèse de fréquence des figures 1, 3, 7 et 8,
- la figure 12 représente schématiquement l'architecture générale d'un mécanisme de correction synchronisée de l'un quelconque des dispositifs de synthèse de fréquence des figures 3, 7 et 8,
- la figure 13 est un chronogramme illustrant les évolutions de données numériques obtenues à l'aide du mécanisme de la figure 10,
- la figure 14 représente schématiquement l'architecture d'un exemple d'accumulateur de phase adapté pour le dispositif de synthèse de fréquence de la figure 3 ou 7,
- la figure 15 représente schématiquement l'architecture d'un exemple d'accumulateur de phase à réduction de dynamique par modulation Delta-Sigma adapté pour le dispositif de synthèse de fréquence de la figure 8, et
- la figure 16 représente schématiquement l'architecture d'un exemple de convertisseur numérique/analogique adapté pour être disposé en sortie de l'accumulateur de phase de la figure 15 dans le dispositif de synthèse de fréquence de la figure 8.

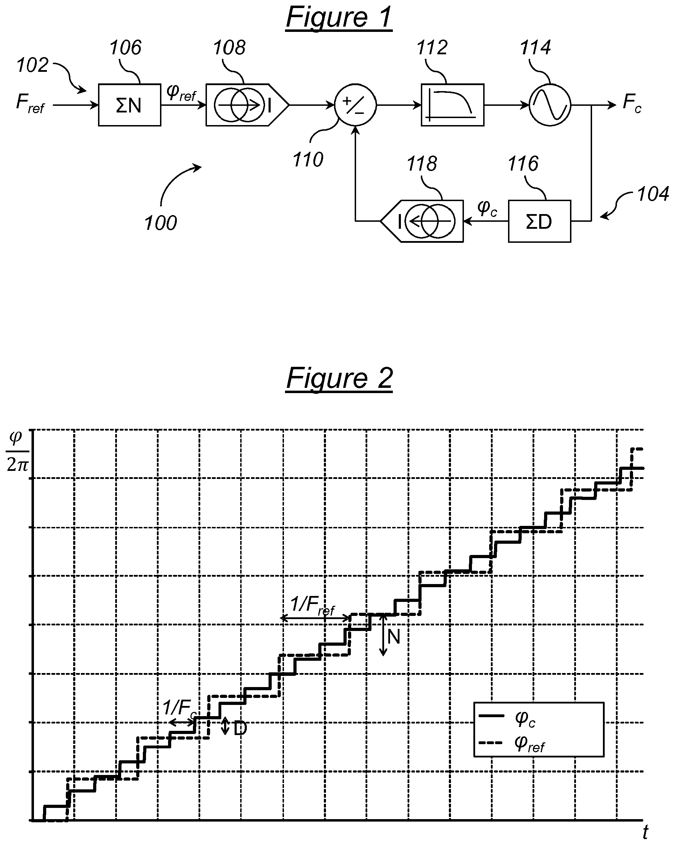

La figure 1 représente schématiquement un dispositif 100 de synthèse de fréquence de type PLL. Ce dispositif 100 présente une entrée destinée à recevoir un signal électrique oscillant à une fréquence de référence $F_{ref}$ et une sortie destinée à fournir un signal électrique oscillant à une fréquence de sortie $F_c$.

Il comporte en outre un circuit 102 d'asservissement de la fréquence de sortie $F_c$ à la fréquence de référence $F_{ref}$ et une boucle de rétroaction 104 pour la fourniture d'informations issues du signal électrique de sortie au circuit d'asservissement 102.

Plus précisément, le circuit d'asservissement 102 relie l'entrée à la sortie du dispositif 100 et comporte :

- un premier accumulateur de phase 106 cadencé à une fréquence liée à la fréquence de référence $F_{ref}$: dans l'exemple de la figure 1, la cadence est directement celle de la fréquence $F_{ref}$ et l'accumulateur de phase 106 présente une valeur entière d'incrément de phase notée N,

- un premier convertisseur numérique/analogique 108 disposé en sortie du premier accumulateur de phase 106, formé par un générateur de courant I, recevant une valeur numérique de phase accumulée $\varphi_{ref}$ fournie par le premier accumulateur de phase 106,

- un comparateur de phases 110 dont une première entrée de comparaison est reliée à la sortie du premier convertisseur numérique/analogique 108,

- un filtre de boucle 112 disposé en sortie du comparateur de phases 110 : dans l'exemple de la figure 1, il s'agit d'un filtre analogique, et

- un oscillateur à fréquence contrôlée 114 disposé en sortie du filtre de boucle 112 et fournissant le signal électrique oscillant à la fréquence de sortie : dans l'exemple de la figure 1, l'oscillateur 114 est de type VCO, c'est-à-dire commandé en tension analogique fournie par le filtre de boucle 112.

Plus précisément également, la boucle de rétroaction 104 récupère le signal électrique fourni par l'oscillateur 114 pour le fournir en entrée d'un deuxième accumulateur de phase 116 cadencé à une fréquence liée à la fréquence de sortie $F_c$ : dans l'exemple de la figure 1, la cadence est directement celle de la fréquence $F_c$ et l'accumulateur de phase 116 présente une valeur entière d'incrément de phase notée D. La boucle de rétroaction 104 comporte en outre un deuxième convertisseur numérique/analogique 118 disposé en sortie du deuxième accumulateur de phase 116, formé par un générateur de courant I de même amplitude maximale que le premier convertisseur numérique/analogique 108, recevant une valeur numérique de phase accumulée $\varphi_c$ fournie par le deuxième accumulateur de phase 116. La sortie du deuxième convertisseur numérique/analogique 118 de la boucle de rétroaction 104 est reliée à une deuxième entrée de comparaison du comparateur de phases 110.

Un accumulateur de phase est, d'une façon générale, un dispositif cadencé selon une fréquence d'horloge prédéterminée pour incrémenter, d'une valeur d'incrément de phase prédéterminée, une valeur numérique fournie en sortie à chaque coup d'horloge.

Ainsi, comme illustré sur la figure 2 par la courbe en traits interrompus pour le premier accumulateur de phase 106 (cadencé par $F_{ref}$ et de valeur d'incrément de phase N), la valeur numérique de phase accumulée $\varphi_{ref}$ est proportionnelle à une rampe temporelle rectiligne théorique de pente $2\pi.N.F_{ref}$. En réalité, elle est échantillonnée à la fréquence $F_{ref}$ et prend des valeurs numériques successives N.i à des instants successifs $t_i$ où i est l'indice des échantillons successifs.

Ainsi également, comme illustré sur la figure 2 par la courbe en trait continu pour le deuxième accumulateur de phase 116 (cadencé par $F_c$ et de valeur d'incrément de phase D), la valeur numérique de phase accumulée $\varphi_c$ est proportionnelle à une rampe temporelle rectiligne théorique de pente $2\pi.D.F_c$. En réalité, elle est échantillonnée à la fréquence $F_c$ et prend des valeurs numériques successives D.j à des instants successifs $t_j$ où j est l'indice des échantillons successifs.

En théorie, à chaque instant t :

$$\left[\varphi_{ref} - \varphi_c\right](t) = 2\pi \cdot t \cdot \left(N \cdot F_{ref} - D \cdot F_c\right).$$

A l'aide du comparateur de phases 110, lorsque la PLL est verrouillée, on retrouve donc bien théoriquement la relation $F_c = \alpha.F_{ref} = N/D.F_{ref}$.

Mais en pratique, les instants $t_i$ et $t_j$ ne sont pas synchronisés entre eux et ne permettent pas une comparaison directe des échantillons de phases accumulées.

Il est donc avantageux et astucieux de :

- convertir la valeur numérique de phase accumulée $\varphi_{ref}$ en un signal analogique en temps continu à l'aide du premier convertisseur numérique/analogique 108,

- convertir la valeur numérique de phase accumulée $\varphi_c$ en un signal analogique en temps continu à l'aide du deuxième convertisseur numérique/analogique 118, et

- comparer les deux signaux analogiques résultants en temps continu à l'aide du comparateur de phases 110, qui peut alors prendre la simple forme d'un soustracteur analogique en temps continu, ou bien d'un additionneur analogique en temps continu si le signe de l'un des deux signaux analogiques à comparer a au préalable été inversé.

En effet, en procédant de la sorte par soustraction analogique de valeurs de phases accumulées plutôt que par une tentative de resynchronisation des échantillons de phases accumulées, ou plutôt que par une comparaison directe de phases de signaux analogiques sans calcul préalable de ces phases, on obtient une fréquence de comparaison totalement indépendante de celle des signaux à comparer. Il devient donc envisageable de concevoir un dispositif de synthèse de fréquence de facteur multiplicatif $\alpha$ = N/D à forte valeur pour D, donc à forte résolution en fréquence, sans conséquences préjudiciables sur le temps d'établissement du régime de fonctionnement et sur les bruits de phases ou autres.

Selon le mode de réalisation détaillé précédemment, les valeurs numériques de phases accumulées $\varphi_{ref}$ et $\varphi_c$ sont respectivement incrémentées des valeurs N et D à chaque coup d'horloge correspondant, c'est-à-dire aux instants $t_i$ pour la valeur numérique représentant la phase accumulée $\varphi_{ref}$ et aux instants $t_j$ pour la valeur numérique représentant la phase accumulée $\varphi_c$. Si rien n'est prévu, ces valeurs numériques sont destinées à croître indéfiniment, ce qui pose alors un problème de saturation des accumulateurs.

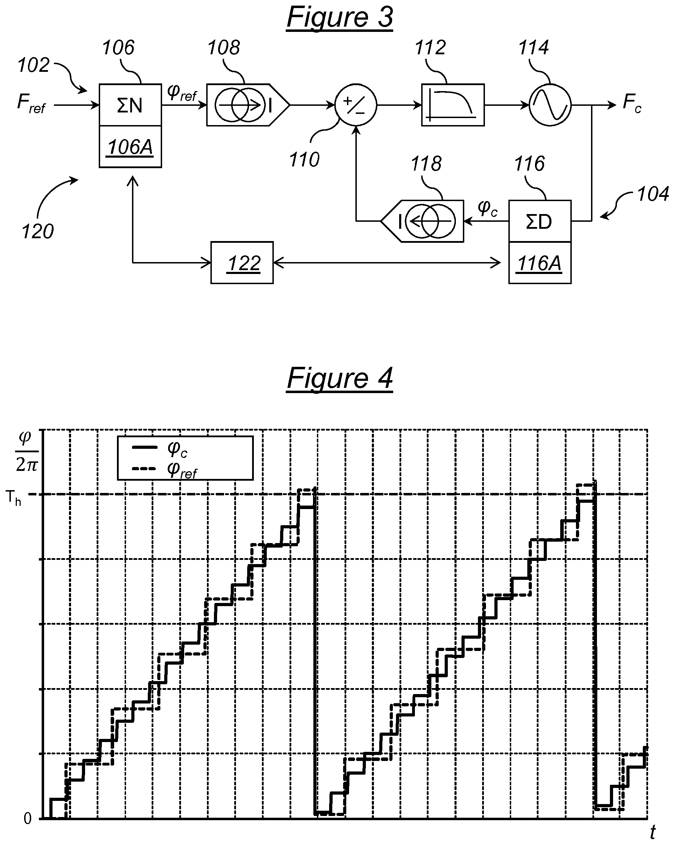

Des solutions simples de remise à zéro des accumulateurs ou de soustraction d'un modulo peuvent être mises en oeuvre lorsque la saturation ou un seuil prédéfini est atteint, mais un mode de réalisation perfectionné, résolvant ce problème de saturation de façon astucieuse, est proposé en référence à la figure 3.

Selon ce deuxième mode de réalisation, un dispositif 120 de synthèse de fréquence de type PLL comporte les mêmes éléments 102 à 118 que le dispositif 100, organisés de la même manière, mais avec un mécanisme supplémentaire 122 de correction synchronisée. Ce mécanisme 122 coopère avec ou est intégré dans des adaptations 106A et 116A des accumulateurs de phases 106 et 116.

Fonctionnellement, le mécanisme de correction synchronisée 122 est conçu pour détecter tout dépassement, par l'un ou l'autre des accumulateurs de phases 106 et 116, d'une valeur seuil commune $T_h$ au-delà de laquelle il est prévu de soustraire une valeur de modulo à la valeur de phase accumulée dans l'un ou l'autre des accumulateurs de phases 106 et 116. Cette valeur de modulo est par exemple égale à la valeur seuil $T_h$. Plus précisément, le mécanisme de correction synchronisée 122 est prévu pour soustraire la valeur de modulo $T_h$ simultanément dans chacun des premier et deuxième accumulateurs de phases 106, 116 dès lors que la valeur seuil commune $T_h$ est dépassée dans chacun des premier et deuxième accumulateurs de phases 106, 116. Cette soustraction est réalisée au même instant, qui est par exemple soit l'un des instants $t_i$, soit l'un des instants $t_j$, en fonction de l'accumulateur qui est le deuxième à atteindre la valeur seuil commune $T_h$. Il pourrait aussi s'agir d'un instant totalement indépendant des signaux d'horloges. Cette synchronisation est réalisée pour éviter toute erreur de modulo dans le calcul de soustraction réalisé par le comparateur de phases 110, étant donné que les deux accumulateurs de phases 106 et 116 dépassent très aléatoirement et très rarement la valeur seuil commune $T_h$ au même instant. Conformément à cette synchronisation, le premier accumulateur de phase 106 ou 116 à atteindre la valeur seuil commune $T_h$ est contraint d'attendre que le deuxième accumulateur de phase 116 ou 106 ait lui aussi atteint cette valeur seuil tout en continuant à incrémenter sa valeur d'accumulation au-delà de la valeur seuil commune $T_h$.

Ainsi, comme illustré sur la figure 4 par la courbe en traits interrompus pour le premier accumulateur de phase 106 (cadencé par $F_{ref}$ et de valeur d'incrément de phase N), la valeur numérique de phase accumulée $\varphi_{ref}$ est proportionnelle à une rampe temporelle en dents de scie théorique de pente $2\pi.N.F_{ref}$. En réalité, elle est échantillonnée à la fréquence $F_{ref}$ et prend des valeurs numériques successives incrémentées de N d'un échantillon au suivant auxquelles sont soustraites la valeur de modulo $T_h$ à chaque intervention du mécanisme de correction synchronisée 122.

Ainsi également, comme illustré sur la figure 4 par la courbe en trait continu pour le deuxième accumulateur de phase 116 (cadencé par $F_c$ et de valeur d'incrément de phase D), la valeur numérique de phase accumulée $\varphi_c$ est proportionnelle à une rampe temporelle en dents de scie théorique de pente $2\pi.D.F_c$. En réalité, elle est échantillonnée à la fréquence $F_c$ et prend des valeurs numériques successives incrémentées de D d'un échantillon au suivant auxquelles sont soustraites la valeur de modulo $T_h$ à chaque intervention du mécanisme de correction synchronisée 122.

Les deux courbes en dents de scie de la figure 4 sont de cette façon synchronisées l'une par rapport à l'autre indépendamment de leurs horloges respectives.

D'un point de vue spectral, après la conversion analogique en temps continu des valeurs numériques issues des deux accumulateurs de phases 106 et 116, réalisée respectivement par les deux convertisseurs 108 et 118, les deux signaux analogiques en temps continu reçus par le comparateur de phases 110 ont une réponse en fréquence très proche d'une droite qui part de la fréquence nulle et qui décroit avec la fréquence.

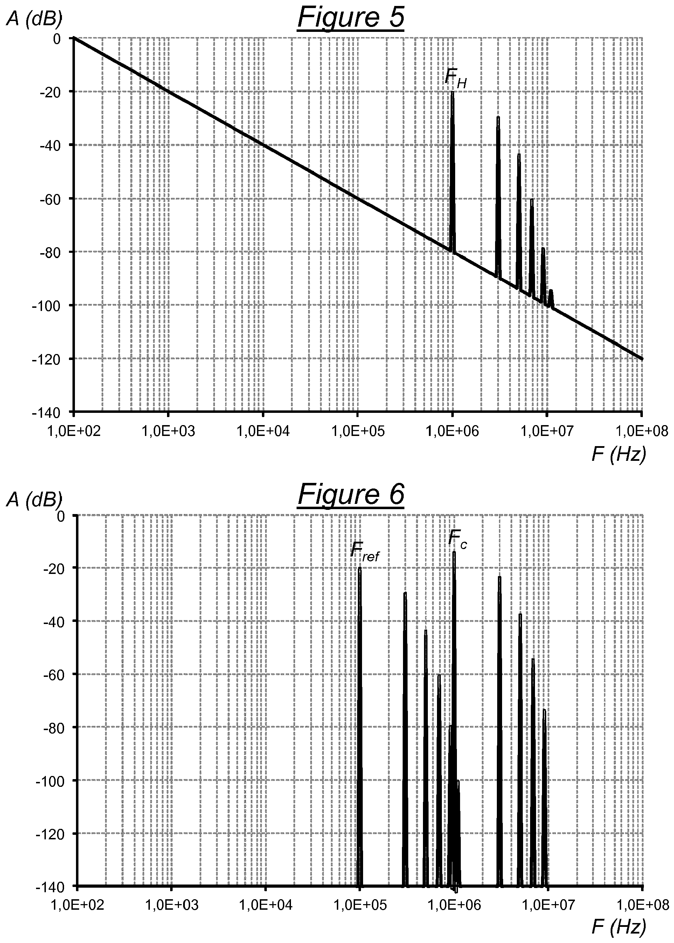

A cet égard, la figure 5 illustre, selon une échelle logarithmique des fréquences, la réponse en fréquence d'un signal analogique en temps continu résultant d'une rampe de phase engendrée par un accumulateur de phase échantillonné par un signal d'horloge de fréquence $F_H$ égale à 1 MHz. Le spectre illustré sur cette figure est ainsi parasité par la fréquence $F_H$ et ses harmoniques, phénomène bien connu de l'homme de l'art. Cependant l'échantillonnage équivalent réalisé par l'accumulateur de phase ne génère ni repliement de spectre ni bruit de quantification car il est appliqué à l'identique à chaque coup d'horloge.

Par ailleurs, comme la soustraction réalisée par le comparateur de phases 110 est une opération linéaire en temps continu, le spectre du résultat de cette opération est une soustraction des spectres des deux signaux analogiques résultant des valeurs numériques de phases accumulées $\varphi_{ref}$ et $\varphi_c$ sans ajout de bruit supplémentaire.

La figure 6 illustre ainsi, selon une échelle logarithmique des fréquences, le spectre résultant en sortie du comparateur de phases 110 pour les valeurs expérimentales de la figure 4. Lorsque la boucle de PLL se stabilise, les droites des réponses en fréquence tendent à se compenser (ici à -140 dB). Seuls émergent les pics parasites des fréquences fondamentales $F_{ref}$, $F_c$ et leurs harmoniques. Lorsque le facteur multiplicatif $\alpha$ est supérieur à 1, le premier pic parasite se trouve à la fréquence $F_{ref}$, alors que dans un dispositif de synthèse de fréquence classique à division entière et à diviseurs de fréquences, il se trouverait à la fréquence $F_{ref}/D$. Il s'agit là d'une amélioration importante qui permet, soit d'augmenter la fréquence de coupure du dispositif de synthèse de fréquence sous condition de stabilité en améliorant d'autant le temps $\Delta t$ d'établissement de son régime de fonctionnement, soit de beaucoup mieux atténuer les parasites et le bruit de phase sans détériorer ce temps $\Delta t$.

Il apparaît également clairement qu'un dispositif de synthèse de fréquence 100 ou 120 tel que décrit précédemment permet d'obtenir un facteur multiplicatif $\alpha$ = N/D à forte valeur pour D et donc à forte résolution en fréquence. En effet, les accumulateurs de phases 106 et 116 peuvent aisément être implémentés avec des moyens de mémorisation de nombres sous forme binaire, en particulier pour des valeurs entières positives telles que N et D. Ils doivent donc juste prévoir un nombre suffisant de bits pour réaliser les opérations arithmétiques d'accumulation de N et D et de comparaison des valeurs de phases accumulées avec la valeur seuil $T_h$.

Etant donné que la différence calculée ensuite par le comparateur de phases 110 est une opération arithmétique qui n'a de sens que si les deux accumulateurs de phases 106 et 116 prévoient le même nombre de bits pour N et D, c'est donc le nombre de bits le plus grand entre la représentation binaire de D et celle de N qui est retenu. De plus l'accumulation étant une somme, un bit supplémentaire de retenue est au minimum nécessaire. Par ailleurs, quand la valeur de seuil $T_h$ est dépassée et qu'elle est soustraite, en tant que modulo, à la valeur d'un accumulateur 106 ou 116, il est préférable que le résultat soit aussi un entier positif ou nul pour conserver la même représentation. A cette fin, $T_h$ doit être choisi supérieur ou égal à la plus grande valeur entre D et N. En conclusion, le nombre minimal de bits nécessaires en sortie du comparateur de phases 110, et donc aussi pour les accumulateurs 106, 116 et les convertisseurs 108, 118 des dispositifs 100 et 120, peut être défini par la relation suivante :

$$ B = \mathrm{ENT}\big[\log_2\big(\mathrm{MAX}(N, D)\big)\big] + 2, $$

où ENT[ ] est la fonction Partie Entière, ENT[ ] + 1 représentant alors la fonction d'arrondi entier supérieur, et où MAX( ) est la fonction qui retourne le maximum entre deux valeurs.

Conformément à ces calculs, les possibilités de choix des valeurs de D et de N pour des valeurs de $\alpha$ et $F_{ref}$ données ne dépendent que de B. Pour B = 32 par exemple, D peut aller jusqu'à $2^{31}$-1 (idem pour N), là où un dispositif de synthèse de fréquence à division entière classique a des valeurs de D limitées à 100 ou 1000. Il s'agit d'une augmentation importante de la résolution en fréquence des variations possibles $F_{ref}$/D du facteur multiplicatif $\alpha$ que peut atteindre un dispositif selon l'invention en fonction de B. La résolution d'un dispositif de synthèse de fréquence à pas fractionnaires peut même être dépassée. Par exemple, pour un signal de référence de 10 MHz et B = 32, la résolution en fréquence est meilleure que 0,005 Hz.

Réciproquement, pour une résolution en fréquence donnée, puisqu'elle est égale à $F_{ref}$/D, il est possible d'augmenter $F_{ref}$ avec D. Cette possibilité est intéressante pour abaisser la contribution du signal de référence au bruit de phase en sortie dans la bande-passante du dispositif de synthèse de fréquence. En effet dans un tel dispositif, cette contribution est directement due à la fonction de multiplication de la fréquence de référence par le facteur multiplicatif a. Plus précisément, dans la bande-passante, la contribution du bruit de phase du signal de référence est augmentée de $20.\log(\alpha)$ en décibels. Il est alors avantageux de diminuer $\alpha$ et donc d'augmenter $F_{ref}$ pour $F_c$ donné.

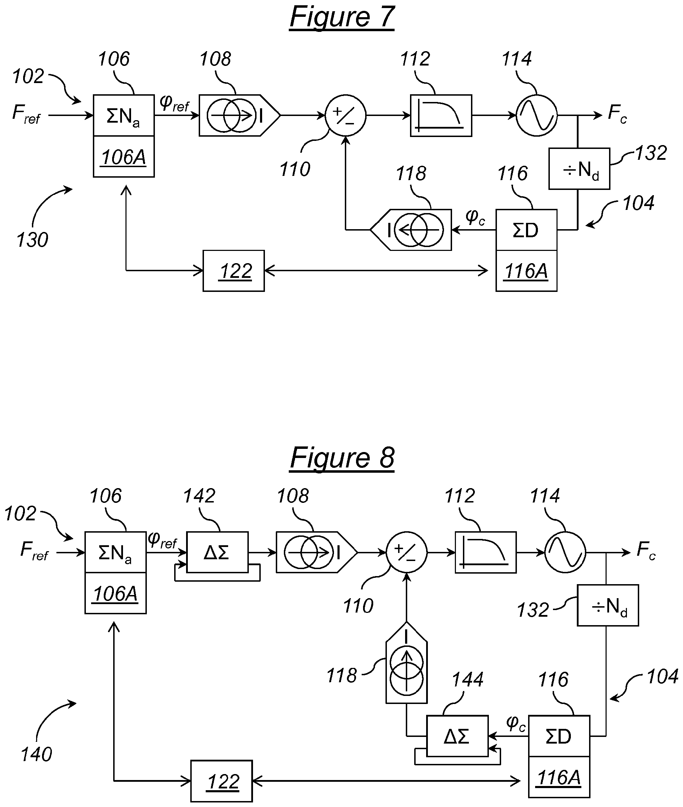

La figure 7 représente schématiquement un dispositif 130 de synthèse de fréquence de type PLL, selon un troisième mode de réalisation de l'invention. Ce dispositif 130 diffère du dispositif 120 en ce qu'il comporte un diviseur de fréquence 132, disposé dans la boucle de rétroaction 104 entre la sortie et le deuxième accumulateur de phase 116, et en ce que la valeur d'incrément de phase du premier accumulateur de phase 106 est adaptée en fonction de la valeur du facteur de division de ce diviseur de fréquence 132 pour un facteur d'asservissement souhaité de la fréquence de sortie $F_c$ à la fréquence de référence $F_{ref}$. Plus précisément, la valeur N est scindée en un produit de deux valeurs $N_a$ et $N_d$, N = $N_a.N_d$, $N_a$ représentant la valeur d'incrément de phase du premier accumulateur de phase 106 et $N_d$ le facteur de division du diviseur de fréquence 132. On conserve ainsi la relation $F_c = \alpha.F_{ref} = N/D.F_{ref} = N_a.N_d/D.F_{ref}$. On notera enfin que le dispositif 130 diffère aussi du dispositif 120 en ce que le deuxième accumulateur de phase 116 n'est plus directement cadencé à la fréquence de sortie $F_c$, mais à la fréquence réduite $F_c/N_d$ qui reste toutefois liée à $F_c$.

L'avantage de ce troisième mode de réalisation par rapport au précédent est d'éviter une trop grande différence entre les valeurs d'incréments de phases des deux accumulateurs de phases 106 et 116 en scindant la valeur de N en deux facteurs entiers. En effet, sachant qu'il est souvent souhaité d'avoir un facteur multiplicatif $\alpha$ largement supérieur à 1, la valeur de N est souvent largement supérieure à celle de D, de sorte que, selon le calcul effectué précédemment en référence aux deux premiers modes de réalisation des figures 1 et 3, le nombre minimal $B$ = ENT[$\log_2$(MAX(N,D))] + 2 est toujours dominé par la valeur de N et pas par celle de D. De la sorte, un certain nombre de bits d'implémentation de la valeur D restent inutiles et ce d'autant plus que le facteur $\alpha$ est grand. Or des bits d'implémentation inutiles signifient autant de portes logiques qui consomment de la puissance inutilement.

Dans le troisième mode de réalisation de la figure 7, le calcul de B devient :

$$ B = \mathrm{ENT}\big[\log_2\big(\mathrm{MAX}(N_a, D)\big)\big] + 2. $$

Puisque $N_a$ est inférieur à N, on réduit le nombre de bits d'implémentation inutiles. De façon avantageuse, on peut même choisir le facteur de division $N_d$ de telle sorte que, pour un facteur d'asservissement souhaité de la fréquence de sortie à la fréquence de référence, $\alpha$ = N/D, la valeur d'incrément de phase D du deuxième accumulateur de fréquence 116 puisse être aussi proche que possible de la valeur d'incrément de phase $N_a$ du premier accumulateur de phase 106 tout en restant inférieure ou égale à cette dernière. Dans ce cas, peu de bits d'implémentation sont inutiles et l'architecture est optimisée en termes de consommation de puissance. Les fréquences d'horloge $F_{ref}$ et $F_c/N_d$ des deux accumulateurs de phases 106 et 116 deviennent également proches l'une de l'autre, celle du deuxième accumulateur de phase 116 étant ralentie de manière à réduire encore la consommation. Cette réduction n'est par ailleurs pas compensée par l'ajout du diviseur de fréquence 132. L'optimum est atteint pour ENT[$log_2(N_a)$] = ENT[$log_2(D)$] = $B$ - 2. Il n'est toutefois pas intéressant que la valeur $N_a$ soit inférieure à D, parce que dans ce cas la première fréquence parasite dans le spectre de sortie ne serait plus $F_{ref}$ mais $F_c/N_d$. Il en résulterait alors, soit une dégradation du temps $\Delta t$ d'établissement du régime de fonctionnement, soit une dégradation de l'atténuation des fréquences parasites, selon la fréquence de coupure choisie pour le filtre de boucle 112.

La contrepartie de cette amélioration en consommation est une perte de résolution en fréquence qui devient $F_{ref}.N_d/D$ et non plus $F_{ref}/D$. Elle est donc dégradée d'un facteur $N_d$.

La figure 8 représente schématiquement un dispositif 140 de synthèse de fréquence de type PLL, selon un quatrième mode de réalisation de l'invention. Ce dispositif 140 diffère du dispositif 130 en ce que chaque convertisseur numérique/analogique 108 ou 118 est précédé d'un dispositif de réduction de dynamique par quantification. Plus précisément, cette réduction de dynamique est par exemple réalisée à l'aide d'un quantificateur à modulation Delta-Sigma. Ainsi, un premier quantificateur à modulation Delta-Sigma 142 est disposé entre le premier accumulateur de phase 106 et le premier convertisseur numérique/analogique 108. De même, un deuxième quantificateur à modulation Delta-Sigma 144 est disposé entre le deuxième accumulateur de phase 116 et le deuxième convertisseur numérique/analogique 118.

Ce mode de réalisation présente l'avantage de faciliter l'implémentation des deux convertisseurs 108 et 118. En effet, sans réduction de dynamique par quantification, pour des valeurs de phases accumulées codées sur B bits en sortie des accumulateurs de phases, la pleine échelle des convertisseurs étant une valeur constante I, la valeur correspondant au bit de poids le plus faible vaut :

$$I_{lsb} = \frac{I}{2^B - 1}.$$

Cette valeur peut devenir très petite lorsque B augmente, c'est-à-dire lorsque la résolution en fréquence est grande. Par exemple, pour I = 100 $\mu$A et B = 32, $I_{lsb} \approx 23$ fA.

Ainsi, la réduction de dynamique permet une réduction du nombre de bits pris en considération dans les convertisseurs, les rendant plus simples à réaliser.

D'une façon générale, pour diminuer le nombre de bits fournis en entrée des convertisseurs, la solution la plus simple consiste à tronquer les valeurs à convertir sur un nombre de bits B' inférieur à B en supprimant les bits de poids faibles. Cette troncature est mathématiquement équivalente à une nouvelle quantification des données numériques. Cette quantification produit une erreur qui est en général assimilée à un bruit, dit bruit de quantification. Ce bruit possède un spectre assez aléatoire mais qu'on approche souvent par un spectre plat de bruit blanc. Les convertisseurs analogique/numérique n'ont alors besoin que de convertir B' bits au prix de parasites assimilables à du bruit supplémentaire dans le spectre de sortie du dispositif de synthèse de fréquence. Du fait de l'asservissement en fréquence, ce bruit se retrouve principalement autour de la fréquence de coupure du dispositif, son écart-type diminuant lorsque B' augmente.

L'intérêt d'utiliser un quantificateur à modulation Delta-Sigma pour réaliser la réduction de dynamique est de réduire ce bruit de quantification, du fait que le comparateur de phases 110 est suivi d'un filtre passe-bas, en l'occurrence le filtre de boucle 112. En effet, la fonction de modulation Delta-Sigma déforme le spectre du bruit de quantification en engendrant moins de bruit à basse fréquence et plus de bruit à haute fréquence proche de $F_{ref}$ et $F_c/N_d$. Ce bruit est alors mieux filtré par le filtre de boucle 112 si les fréquences $F_{ref}$ et $F_c/N_d$ sont suffisamment grandes devant la fréquence de coupure du dispositif. On notera qu'en pratique l'ordre du filtre doit être strictement supérieur à celui de la modulation Delta-Sigma. Dans ce quatrième mode de réalisation, le filtre de boucle 112 est donc au minimum d'ordre 2, sachant qu'en outre il ne peut pas être d'ordre trop élevé, c'est-à-dire qu'il reste avantageusement d'ordre inférieur ou égal à 3.

A titre d'exemple non limitatif, un quantificateur à modulation Delta-Sigma d'ordre 1 est très simple à implémenter car il est toujours stable. Il peut être constitué d'un additionneur suivi d'un registre de B bits + 1 bit de retenue, dont la sortie est tronquée en prenant les B' bits de poids forts tandis que les (B + 1 - B') bits de poids faibles restants sont complétés par des 0 en poids forts pour obtenir une nouvelle donnée sur B bits en entrée. La valeur de la nouvelle donnée ainsi créée représente la fraction qui a été tronquée en sortie du registre. Cette valeur est additionnée à la donnée courante d'entrée sur B bits et le résultat enregistré dans le registre pour le cycle suivant. C'est de cette façon que le quantificateur à modulation Delta-Sigma n'efface jamais l'erreur de quantification, en la reportant dans le temps.

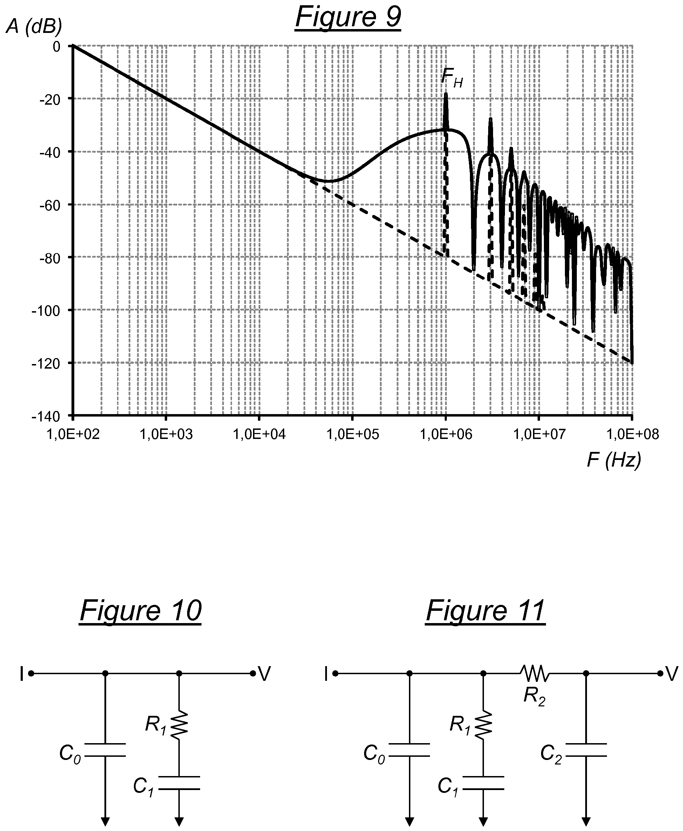

La figure 9 illustre, selon une échelle logarithmique des fréquences, la réponse en fréquence d'un signal analogique en temps continu résultant :

-   d'une rampe de phase engendrée par un accumulateur de phase soumis à un signal d'horloge de fréquence $F_H$ égale à 1 MHz, et
- d'une réduction de dynamique par quantification réalisée en sortie de l'accumulateur à l'aide d'un quantificateur à modulation Delta-Sigma.

En plus d'être parasité par la fréquence $F_H$ et ses harmoniques, le spectre illustré sur cette figure présente un bruit de quantification reporté principalement autour de ces fréquences parasites, sans changement sensible aux fréquences basses si on le compare au spectre de la figure 5. Ce bruit est destiné à être filtré par le filtre de boucle 112, et ce d'autant mieux de $F_{ref}$ est grand par rapport à la fréquence de coupure du dispositif. Etant donné qu'un dispositif de synthèse de fréquence selon l'invention permet d'augmenter la fréquence de référence facilement à facteur multiplicatif α constant, il se démarque, aussi du point de vue de l'utilisation d'une modulation Delta-Sigma, d'un dispositif de synthèse de fréquence à pas fractionnaires dans lequel cette fréquence de référence est plus difficile à augmenter.

Il apparaît clairement qu'un dispositif de synthèse de fréquence tel que l'un de ceux décrits précédemment comporte au moins une partie des avantages suivants, celui du quatrième mode de réalisation détaillé ci-dessus les cumulant tous :

- une grande résolution en fréquence du réglage du signal de sortie peut être atteinte et n'est pratiquement pas tributaire de la fréquence de référence,
- contrairement aux dispositifs de synthèse de fréquence à pas fractionnaires, cette grande résolution en fréquence n'est pas obtenue au détriment d'un bruit de phase injecté dans le signal de sortie,
- il se comporte comme un dispositif de synthèse de fréquence à division entière classique avec une fonction de transfert très proche, de sorte que son étude en est simplifiée,
- la fréquence $F_{ref}$ du signal de référence peut être aussi grande que souhaitée, sa contribution au bruit de phase total en sortie, $20.\log(\alpha)$, étant diminuée d'autant pour une fréquence de sortie $F_c$ donnée,
- les signaux parasites présents dans le spectre de sortie sont décalés vers les hautes fréquences, de sorte qu'ils sont mieux filtrés par le filtre de boucle,
- sa fréquence de coupure peut être augmentée dans les limites de la stabilité, de sorte que le temps d'établissement de son régime de fonctionnement peut être diminué, et
- la résolution en fréquence ne dépend pas du nombre de bits pris en compte dans les convertisseurs numérique/analogique utilisés.

En termes d'application industrielle, l'un quelconque des dispositifs décrits précédemment peut être intégré dans tout dispositif nécessitant une synthèse de fréquence, comme par exemple un récepteur ou émetteur radiofréquence, une horloge de cadencement de circuits numériques, analogiques ou mixtes (i.e. analogiques et numériques), un système de mesure cadencé, une base de temps, etc.

On va maintenant donner des exemples concrets d'architectures électroniques pour chacun des éléments fonctionnels constitutifs des dispositifs de synthèse de fréquence décrits précédemment.

La figure 10 illustre un exemple de filtre d'ordre 1 pouvant être choisi pour réaliser le filtre de boucle 112 de l'un quelconque des dispositifs de synthèse de fréquence des figures 1, 3 et 7. Ce filtre d'ordre 1 reçoit en entrée un courant analogique I de la part du comparateur de phases 110 et fournit en sortie une tension de commande analogique V à l'oscillateur 114. Il comporte en outre un premier circuit capacitif $C_0$ reliant l'entrée à la masse pour réaliser une fonction d'intégration en insérant un pôle à la fréquence nulle. Il comporte en outre un deuxième circuit résistif et capacitif $R_1$, $C_1$ reliant la sortie à la masse pour créer une marge de phase en insérant un zéro à basse fréquence. Ce filtre d'ordre 1 ne peut pas être utilisé dans le dispositif de synthèse de fréquence de la figure 8 puisqu'il ne peut pas être d'ordre strictement supérieur à celui des quantificateurs Delta-Sigma 142 et 144.

La figure 11 illustre un exemple de filtre d'ordre 2 pouvant être choisi pour réaliser le filtre de boucle 112 de l'un quelconque des dispositifs de synthèse de fréquence des figures 1, 3, 7 et 8. Ce filtre d'ordre 2 diffère du filtre de la figure 10 en ce qu'un troisième circuit résistif $R_2$ s'interpose entre le deuxième circuit $R_1$, $C_1$ et la sortie, et en ce qu'un quatrième circuit capacitif $C_2$ relie la sortie à la masse. Ces deux circuits supplémentaires ajoutent un pôle au-delà de la fréquence de coupure du filtre.

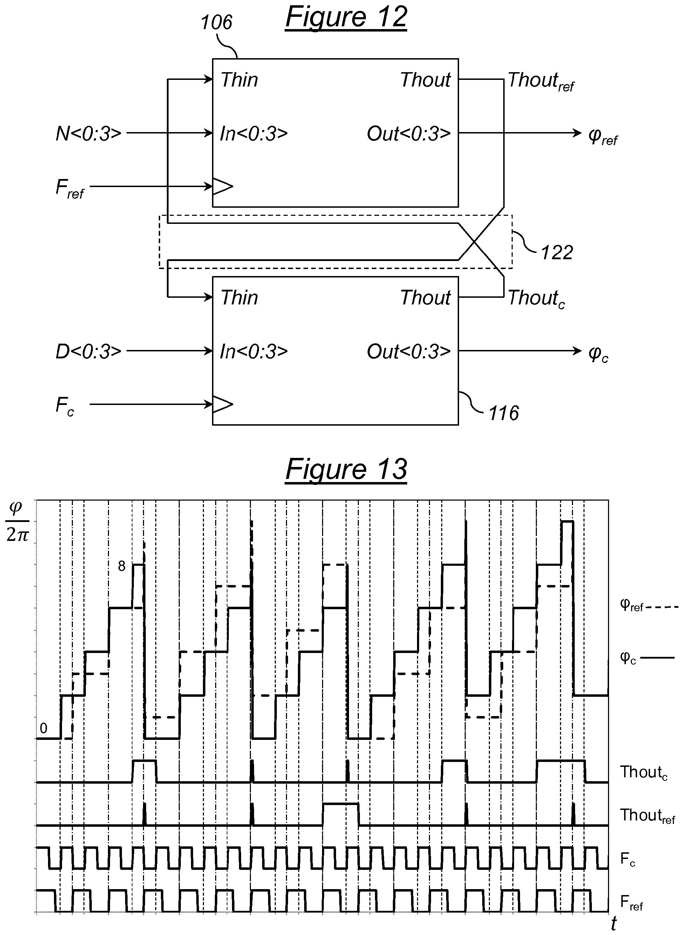

La figure 12 représente schématiquement l'architecture générale d'un mécanisme de correction synchronisée 122 coopérant avec les deux accumulateurs de phases 106, 116 de l'un quelconque des dispositifs de synthèse de fréquence des figures 3, 7 et 8.

Chaque accumulateur de phase 106 ou 116 est cadencé selon une fréquence prédéterminée, $F_{ref}$ pour l'accumulateur 106 et $F_c$ pour l'accumulateur 116, et stocke une valeur d'incrément de phase qu'il reçoit éventuellement, N (ou $N_a$) pour l'accumulateur 106 et D pour l'accumulateur 116, dans un registre d'entrée In. Un registre de sortie Out est incrémenté de la valeur d'incrément de phase à chaque coup d'horloge pour la fourniture en sortie d'une valeur numérique de phase accumulée, $\varphi_{ref}$ pour l'accumulateur 106 et $\varphi_c$ pour l'accumulateur 116.

Par ailleurs, chaque accumulateur de phase 106 ou 116 est adapté, selon un exemple d'adaptation 106A pour l'accumulateur 106 et selon un exemple d'adaptation 116A pour l'accumulateur 116, pour recevoir sur une entrée Thin, indépendamment de ses coups d'horloge, un signal binaire de dépassement de la valeur seuil $T_h$ par l'autre accumulateur et pour fournir sur une sortie Thout un signal binaire de dépassement de la valeur seuil $T_h$ par lui-même. Le signal binaire de dépassement de seuil de la sortie Thout passe et reste à 1 lorsque la valeur seuil $T_h$ a été atteinte ou dépassée par l'accumulateur correspondant. Il est à 0 sinon.

Dans ce contexte, le mécanisme de correction synchronisée 122 comporte :

- un raccordement pour le transfert de la valeur courante du signal binaire Thout$_{ref}$ de dépassement de la valeur seuil $T_h$ par l'accumulateur 106 vers l'entrée Thin de l'accumulateur 116, et
- un raccordement pour le transfert de la valeur courante du signal binaire Thout$_c$ de dépassement de la valeur seuil $T_h$ par l'accumulateur 116 vers l'entrée Thin de l'accumulateur 106.

Dans chaque accumulateur de phase 106, 116, la valeur de modulo est soustraite à la valeur stockée dans le registre de sortie Out dès que l'entrée Thin et la sortie Thout sont à 1.

Dans l'exemple précis et non limitatif de la figure 12, les valeurs d'incréments de phase N (ou $N_a$) et D sont codées sur 4 bits et les registres In, Out occupent 4 bits de mémoire. La valeur seuil $T_h$, qui est égale à la valeur de modulo, vaut 8.

La figure 13 illustre un exemple de chronogramme obtenu conformément à cet exemple, avec N = 3 et D = 2, pour les horloges de fréquences $F_{ref}$, $F_c$ et les valeurs numériques Thout$_{ref}$, Thout$_c$, $\varphi_{ref}$ et $\varphi_c$. Il est clairement visible que l'accumulateur de phase qui passe la valeur seuil $T_h$ en premier génère une impulsion positive sur la sortie Thout beaucoup plus longue que pour l'autre accumulateur de phase car il est en attente. On peut noter également que les fronts descendants des signaux binaires de dépassement de la valeur seuil ont toujours lieu sur des fronts montants de leurs horloges respectives.

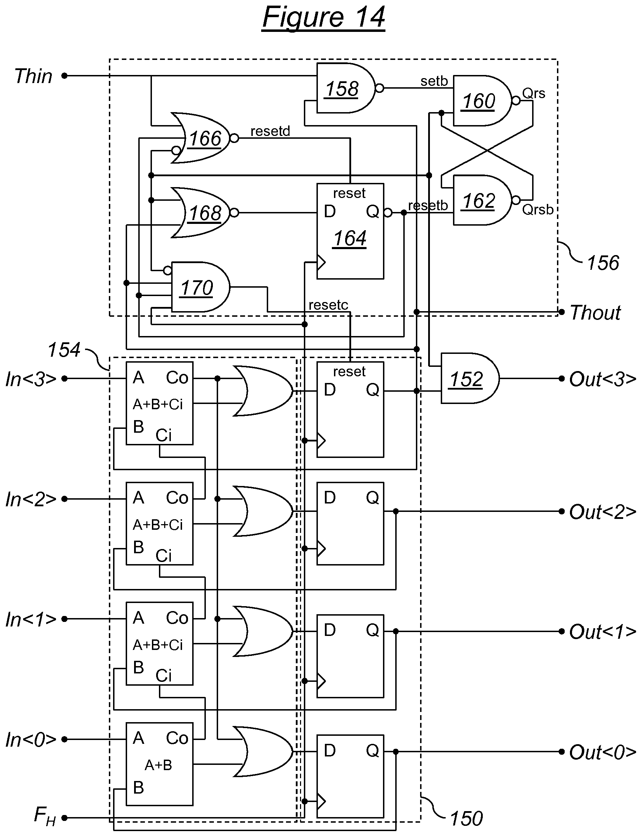

La figure 14 représente schématiquement l'architecture générale, en termes de registres et portes logiques, d'un exemple d'accumulateur de phase 106 ou 116 adapté pour le dispositif de synthèse de fréquence de la figure 3 ou 7. Cet exemple est en particulier adapté au cas précis illustré dans la figure 12 selon lequel les valeurs d'incréments de phase N (ou $N_a$) et D sont codées sur 4 bits et les registres In, Out occupent 4 bits de mémoire.

Cette architecture comporte un registre de mémorisation 150 à quatre bascules synchrones cadencées par la fréquence d'horloge $F_H$ ($F_{ref}$ pour l'accumulateur de phase 106 et $F_c$ pour l'accumulateur de phase 116). Les quatre sorties binaires de ce registre 150 alimentent les quatre bits Out<0>, Out<1>, Out<2>, Out<3> du registre de sortie Out, par l'intermédiaire d'une porte logique ET 152 en ce qui concerne le bit de poids fort Out<3>. Les quatre entrées binaires de ce registre 150 sont alimentées par un additionneur 4 bits 154 à quatre modules d'additions binaires reliés entre eux de façon classique pour réaliser une addition sur 4 bits. Les quatre bits In<0>, In<1>, In<2>, In<3> du registre d'entrée In alimentent quatre entrées respectives des modules d'additions binaires de l'additionneur 154, lesquels reçoivent également les quatre sorties binaires du registre de mémorisation 150 pour réaliser l'opération d'accumulation. Les sorties des quatre modules d'additions binaires sont fournies à quatre portes logiques OU respectives de l'additionneur 154 également toutes alimentées par la retenue « Co » du module d'addition binaire relatif au bit de poids fort In<3>. Cette prise en compte de la dernière retenue à l'aide des portes logiques OU est établie pour saturer le résultat de l'additionneur 154 sur chacun des bits afin d'éviter tout retour à zéro intempestif pendant le temps d'établissement du régime de fonctionnement du dispositif de synthèse de fréquence.

L'architecture de la figure 14 comporte en outre un circuit 156 de détection de dépassement de la valeur seuil $T_h$ et d'application de la valeur de modulo. Ces deux valeurs sont, dans cet exemple, égales à 8, ce qui correspond au bit de poids fort du registre de mémorisation à 1 pour une implémentation particulièrement simple. La détection du dépassement de la valeur seuil $T_h$ consiste donc à détecter le passage à 1 de ce bit de poids fort qui est pour cela relié à la sortie Thout, laquelle transmet instantanément sa valeur à l'entrée Thin de l'autre accumulateur de phase. La soustraction de la valeur de modulo consiste à remettre ce bit à zéro, ce qui peut être réalisé de façon asynchrone par un signal « resetc » fourni par le circuit 156, ce signal s'appliquant de façon asynchrone à la bascule synchrone de poids fort du registre de mémorisation 150. La soustraction de la valeur de modulo peut également être réalisée en forçant à zéro le bit Out<3> du registre de sortie Out à l'aide de la porte logique ET 152 qui reçoit non seulement la valeur du bit de poids fort du registre de mémorisation 150 (i.e. la valeur de la sortie Thout), mais également un signal « Qrsb » fourni par le circuit 156.

Le circuit 156 reçoit la valeur de l'entrée Thin sur une porte logique ET 158 qui reçoit également la valeur de Thout et dont la sortie est inversée pour fournir un signal « setb » en entrée d'une porte logique NON-ET 160 d'une bascule RS dont l'autre porte logique NON-ET 162 fournit le signal « Qrsb ». Ce signal « Qrsb » est également fourni en entrée de la porte logique NON-ET 160 qui fournit à son tour un signal « Qrs » en entrée de la porte logique NON-ET 162. Cette porte logique NON-ET 162 reçoit également un signal « resetb » fourni par la sortie inversée d'une bascule synchrone 164 cadencée par la fréquence d'horloge $F_H$.

Le circuit 156 comporte en outre une porte logique NON-OU 166 à trois entrées dont une inverseuse : la valeur de l'entrée Thin et le signal « resetb » sont fournis en entrées non inverseuses de la porte logique NON-OU 166, tandis que l'entrée inverseuse reçoit le signal « Qrsb ».

Le circuit 156 comporte en outre une porte logique NON-OU 168 qui reçoit le signal « Qrsb » et la valeur de la sortie Thout. Sa sortie inversée est raccordée à l'entrée de la bascule synchrone 164.

Enfin, le circuit 156 comporte une porte ET 170 à quatre entrées dont une inverseuse : l'une des entrées non inverseuses est cadencée par la fréquence d'horloge $F_H$, les deux autres reçoivent le signal « resetb » et la valeur de la sortie Thout, tandis que l'entrée inverseuse reçoit le signal « Qrsb». Cette porte ET 170 fournit le signal « resetc ».

Le circuit 156 fonctionne de la façon suivante. Pour que le signal « resetc » remette à zéro le bit de poids fort du registre de mémorisation 150, il faut que les valeurs de l'entrée Thin et de la sortie Thout passent à 1 toutes les deux et que cela mette à 0, par le signal « setb », le signal « Qrsb » fourni par la bascule RS 160, 162. Une fois que le signal « Qrsb » est à 0, c'est la porte ET 170 qui réalise la remise à zéro mais à condition que le signal d'horloge soit aussi à 1 afin d'éviter d'être trop proche du temps de prépositionnement (de l'anglais « setup ») de la bascule synchrone gérant le bit de poids fort du registre de mémorisation 150, celle-ci étant active sur les fronts montants du signal d'horloge. Par son passage à 0, le signal « Qrsb » indique précisément l'instant où les deux accumulateurs de phases 106 et 116 ont passé la valeur seuil $T_h$.

Cependant, grâce à la bascule synchrone 164 et son signal « resetb », la bascule RS 160, 162 n'est pas réinitialisée en même temps sur les deux accumulateurs de phases afin de tenir compte des temps de prépositionnement et de maintien (de l'anglais « hold ») des bascules synchrones par rapport à leurs cadences respectives. Plus précisément, la bascule RS 160, 162 est mise à 0 par le signal « resetb » au moment du front montant du signal d'horloge de fréquence $F_H$. Grâce à la porte logique NON-OU 168, cela se produit quand la valeur de la sortie Thout est effectivement à 0 et tant que le signal « Qrsb » est à 0. Par ailleurs, la bascule synchrone 164 peut elle-même être remise à zéro par le signal « resetd ». Cela permet d'empêcher la mise à 0 de la bascule RS 160, 162 tant que la valeur de l'entrée Thin n'est pas passée à 1 au travers de la porte logique NON-OU 166. C'est ce mécanisme qui valide la synchronisation des deux accumulateurs de phases.

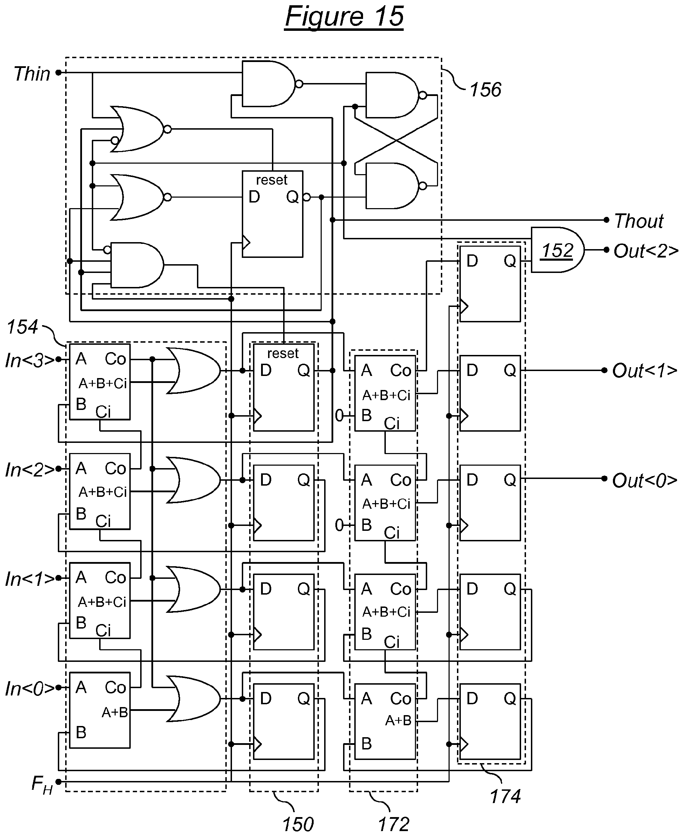

La figure 15 représente schématiquement l'architecture générale, en termes de registres et portes logiques, d'un exemple d'accumulateur de phase 106 ou 116 combiné avec un quantificateur Delta-Sigma 142 ou 144, adapté pour le dispositif de synthèse de fréquence de la figure 8. Cet exemple est en particulier adapté au cas précis illustré dans la figure 12 selon lequel les valeurs d'incréments de phase N (ou $N_a$) et D sont codées sur 4 bits et les registres In, Out occupent 4 bits de mémoire.

Conformément à cet exemple, la fonction d'accumulation de phase est réalisée par le registre de mémorisation 150, l'additionneur 4 bits 154 et le circuit 156, disposés comme précédemment dans l'exemple de la figure 14. La fonction de réduction de dynamique à l'aide d'un quantificateur à modulation Delta-Sigma est réalisée par un additionneur 4 bits supplémentaire 172 et par un registre de mémorisation supplémentaire 174, ces deux modules s'interposant entre le registre de mémorisation 150 et la porte logique ET 152.

Plus précisément, l'additionneur supplémentaire 172 comporte quatre modules d'additions binaires reliés entre eux de façon classique pour réaliser une addition sur 4 bits. Les quatre bits de sortie de l'additionneur 154 alimentent quatre entrées respectives des modules d'additions binaires de l'additionneur supplémentaire 172, lesquels reçoivent également soit des 0, soit des sorties du registre de mémorisation supplémentaire 174 en fonction de la réduction de dynamique souhaitée.

Par exemple, pour obtenir un registre de sortie Out sur 3 bits Out<0>, Out<1>, Out<2>, le registre de mémorisation supplémentaire 174 comporte cinq bascules synchrones cadencées par la fréquence d'horloge $F_H$, parmi lesquelles :

- les deux premières bascules synchrones relatives aux deux bits de poids les plus faibles reçoivent les sorties respectives des deux modules d'additions binaires de ces deux bits pour leur refournir ces valeurs en entrée au coup d'horloge suivant,
- les deux bascules synchrones suivantes relatives aux deux bits de poids les plus forts reçoivent les sorties respectives des deux modules d'additions binaires de ces deux bits pour fournir en sortie des valeurs destinées au registre Out,
- la cinquième et dernière bascule synchrone reçoit la retenue Co du module d'addition binaire relatif au bit de poids le plus fort pour fournir en sortie une valeur destinée au registre Out.

Les deux modules d'additions binaires relatifs aux deux bits de poids les plus forts reçoivent des 0.

Le bit Out<2> est déterminé par la sortie de la porte logique ET 152 dont une entrée est toujours alimentée par le signal « Qrsb » mais dont l'autre entrée est alimentée par la sortie de la dernière bascule synchrone du registre de mémorisation supplémentaire 172.

Le bit Out<1> est déterminé par la sortie de la quatrième bascule synchrone du registre de mémorisation supplémentaire 174.

Enfin, le bit Out<0> est déterminé par la sortie de la troisième bascule synchrone du registre de mémorisation supplémentaire 174.

On obtient ainsi un quantificateur sur 3 bits à modulation Delta-Sigma d'ordre 1 toujours stable. Les deux bits de poids forts qui ont été tronqués représentent la sortie arrondie et sont remplacés par des zéros sur les entrées correspondantes de l'additionneur supplémentaire 172. Pour ces bits, l'addition ne consiste ainsi qu'à additionner et propager la retenue du bit de poids inférieur. De cette façon le résultat est la somme de la valeur de phase accumulée courante sur 4 bits et de la fraction sur 2 bits soustraite au résultat précédent retardé d'une période d'horloge. Il s'agit bien de la somme intégrale de l'erreur de quantification, ce qui est le principe d'une modulation Delta-Sigma. Lorsque l'on utilise une telle architecture pour implémenter les quantificateurs à modulation Sigma-Delta 142 et 144, il est avantageux utiliser l'architecture de la figure 11 pour implémenter le filtre de boucle 112.

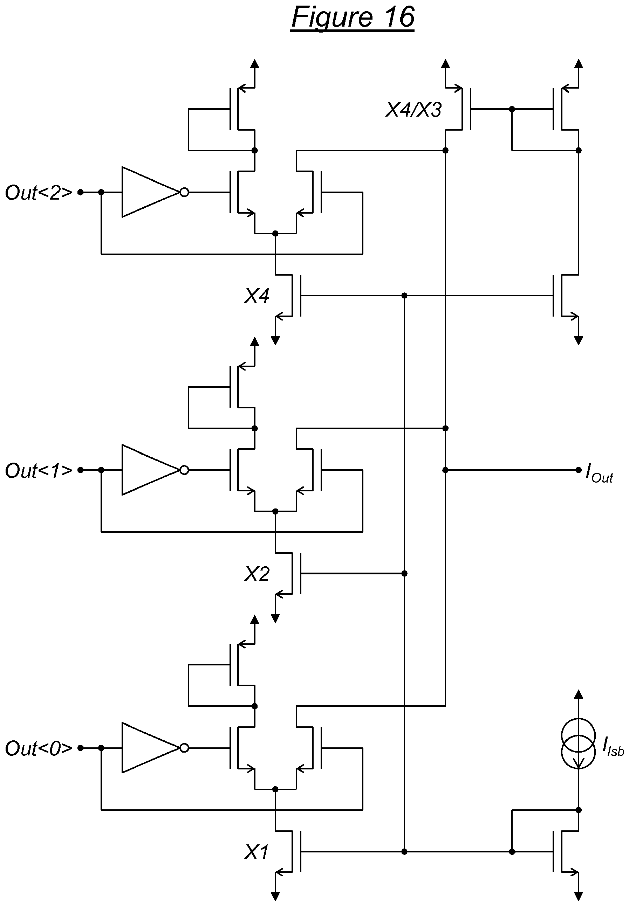

La figure 16 représente schématiquement l'architecture générale d'un exemple de convertisseur analogique/numérique 108 ou 118, adapté pour être disposé en sortie de l'ensemble accumulateur/quantificateur 106/142 ou 116/144 de la figure 15 dans le dispositif de synthèse de fréquence de la figure 8. De nombreux convertisseurs peuvent convenir mais cette figure illustre un convertisseur CNA à courant aiguillé (de l'anglais « steering current DAC »)

Ce convertisseur analogique/numérique reçoit en entrée les données du registre Out sur les 3 bits Out<0>, Out<1>, Out<2> mais pourrait être simplement adapté pour être étendu à un plus grand nombre de bits. Il présente l'avantage de fournir directement un courant signé $I_{Out}$ à sa sortie.

Il est basé sur des miroirs de courant avec un facteur multiplicateur en puissance de 2, ces miroirs étant réalisés à partir d'un courant de référence $I_{lsb}$. Le bit de poids faible Out<0> de la donnée binaire d'entrée utilise un miroir X1, le bit de poids suivant Out<1> un miroir X2 et le bit de poids fort Out<2> un miroir X4. Le courant est aiguillé par une paire différentielle de transistors NMOS commandée par un bit d'entrée et son complémentaire. Quand ce bit est à 1 le courant correspondant est sommé sur la sortie $I_{Out}$. Sinon il est appliqué à un transistor PMOS monté en résistance vers l'alimentation. Ce dernier permet de maintenir la polarisation du miroir. Par cette méthode de sommation de courant, la dynamique de courant sur $I_{Out}$ va de 0 à 7.$I_{lsb}$. Un autre miroir de courant formé de transistors PMOS complémentaires permet de sommer sur $I_{Out}$ un courant inverse de 4.$I_{lsb}$ ou 3.$I_{lsb}$. La fonction de transfert du convertisseur devient donc : $I_{Out}$ t = (4-Out).$I_{lsb}$ ou $I_{Out}$ = (3-Out).$I_{lsb}$ dans le sens du courant sortant. On choisit $I_{lsb}$ tel que : $I_{lsb} = I/(2^3-1) = I/7$.

On notera que le convertisseur analogique/numérique 108 ou 118 n'est pas, a *priori,* cadencé par une fréquence d'horloge. En particulier, ses composants relatifs à tout bit concerné par la valeur seuil $T_h$ ne sont avantageusement pas soumis à la fréquence d'horloge. En revanche, ses autres composants peuvent l'être.

En ce qui concerne l'architecture du comparateur de phases 110, dans le cas où les deux convertisseurs numérique/analogique 108 et 118 sont tels que l'exemple illustré sur la figure 16, elle est par exemple réduite à sa plus simple expression en reliant leurs sorties $I_{Out}$ mais en prenant soin d'inverser bit à bit la valeur binaire fournie en entrée du convertisseur 118. De cette façon, la valeur appliquée au convertisseur 118 vaut 7-$\varphi_{ref}$ qui permet d'obtenir le courant opposé en sortie. Lorsque les courants des deux convertisseurs numérique/analogique 108 et 118 s'additionnent en sortie, on obtient $I_f = I_{lsb}.(1+\varphi_{ref}-\varphi_c)$ qui est le courant qui sera appliqué au filtre de boucle 112. L'offset de courant $I_{lsb}$ restant peut éventuellement être supprimé en passant de X4 à X3 le facteur du miroir de courant PMOS d'un des deux convertisseurs. On a alors $I_f = I_{lsb}.(\varphi_{ref}-\varphi_c)$.

En ce qui concerne les architectures générales de l'oscillateur à fréquence contrôlée 114 et du diviseur de fréquence 132, elles sont bien connues et ne seront pas détaillées. L'oscillateur 114 est par exemple un oscillateur commandé en tension formé d'une auto inductance mise en parallèle avec deux varactors disposés tête-bêche et de deux transistors NMOS dont les grilles sont montées tête-bêche de manière à engendrer un gain suffisant pour amorcer puis entretenir l'oscillation aux bornes de l'auto inductance, ces transistors étant polarisés grâce au courant issu de l'alimentation du point milieu de l'auto inductance.

## Revendications

1. Dispositif (100 ; 120 ; 130 ; 140) de synthèse de fréquence à boucle de rétroaction comportant :

   - une entrée destinée à recevoir un signal électrique oscillant à une fréquence de référence ($F_{ref}$),
   - une sortie destinée à fournir un signal électrique oscillant à une fréquence de sortie ($F_c$),
   - un circuit (102) d'asservissement de la fréquence de sortie ($F_c$) à la fréquence de référence ($F_{ref}$), reliant l'entrée à la sortie du dispositif et comportant un premier accumulateur de phase (106) cadencé à une fréquence liée à la fréquence de référence ($F_{ref}$), un comparateur analogique de phases (110), un premier convertisseur numérique/analogique (108) disposé entre le premier accumulateur de phase (106) et le comparateur analogique de phases (110), un filtre de boucle (112) et un oscillateur (114) à fréquence contrôlée fournissant le signal électrique oscillant à la fréquence de sortie ($F_c$), et
   - une boucle de rétroaction (104) reliant la sortie à l'une de deux entrées de comparaison du comparateur analogique de phases (110), comportant un deuxième accumulateur de phase (116) cadencé à une fréquence liée à la fréquence de sortie ($F_c$) et un deuxième convertisseur numérique/analogique (118) disposé entre le deuxième accumulateur de phase (116) et le comparateur analogique de phases (110),

   dans lequel :

   - le premier convertisseur numérique/analogique (108), respectivement le deuxième convertisseur numérique/analogique (118), est disposé pour fournir en sortie un signal qui est une représentation analogique en temps continu d'une valeur numérique de phase accumulée

(φ_{ref}, φ_c) qui lui est fournie par le premier accumulateur de phase (106), respectivement le deuxième accumulateur de phase (116),
- le comparateur analogique de phases (110) est un additionneur ou soustracteur en temps continu des signaux analogiques en temps continu qui lui sont fournis en entrée par les premier et deuxième convertisseurs numérique/analogique (108, 118),
- les premier (106) et deuxième (116) accumulateurs de phases présentent une valeur seuil (T_h) commune de phase accumulée au-delà de laquelle il est prévu de soustraire une valeur de modulo (T_h) à la valeur de phase accumulée dans chacun des premier (106) et deuxième (116) accumulateurs de phase, et
- un mécanisme (106A, 116A, 122) de synchronisation est prévu pour soustraire la valeur de modulo (T_h) dans chacun des premier (106) et deuxième (116) accumulateurs de phases dès lors que la valeur seuil commune (T_h) est dépassée dans chacun des premier (106) et deuxième (116) accumulateurs de phase,

**caractérisé en ce que** le mécanisme (106A, 116A, 122) de synchronisation est conçu pour que cette soustraction de la valeur de modulo (T_h) soit réalisée à un même instant de la façon suivante :

- le mécanisme (106A, 116A, 122) de synchronisation est conçu pour que la soustraction de la valeur de modulo (T_h) comporte une remise à zéro asynchrone de deux bascules synchrones respectives à sorties binaires de poids le plus fort de deux registres de mémorisation (150) respectifs des premier (106) et deuxième (116) accumulateurs de phases, et
- le mécanisme (106A, 116A, 122) de synchronisation de chacun des premier (106) et deuxième (116) accumulateurs de phases comporte, pour réaliser la soustraction de la valeur de modulo (T_h) audit même instant, une porte logique ET (152) recevant la valeur de la sortie binaire de la bascule synchrone de poids le plus fort du registre de mémorisation (150) et un signal (Qrsb) indiquant ledit même instant où les premier (106) et deuxième (116) accumulateurs de phases ont dépassé la valeur seuil de manière à forcer à zéro audit même instant le bit de poids le plus fort (Out<3>) de la sortie du registre de mémorisation (150) le cas échéant.

2. Dispositif (100 ; 120 ; 130 ; 140) de synthèse de fréquence selon la revendication 1, dans lequel une réduction de dynamique par quantification est prévue entre chaque accumulateur de phase (106, 116) et chaque convertisseur numérique/analogique (108, 118) respectif, cette quantification étant réalisée par troncature de valeurs numériques de phases accumulées, codées sur B bits en sortie de chaque accumulateur de phase (106, 116), sur un nombre de bits B' inférieur à B.

3. Dispositif (100 ; 120 ; 130 ; 140) de synthèse de fréquence selon la revendication 2, dans lequel chaque troncature est réalisée par suppression des B-B' bits de poids faibles des valeurs numériques de phases accumulées.

4. Dispositif (100 ; 120 ; 130 ; 140) de synthèse de fréquence selon la revendication 2 ou 3, dans lequel chaque réduction de dynamique est réalisée par un quantificateur à modulation Delta-Sigma (142, 144).

5. Dispositif (120 ; 130 ; 140) de synthèse de fréquence selon l'une quelconque des revendications 1 à 4, dans lequel le mécanisme (106A, 116A, 122) de synchronisation de chacun des premier (106) et deuxième (116) accumulateurs de phases comporte une porte logique ET (170) commandant la remise à zéro asynchrone sous une condition supplémentaire portant sur la valeur binaire d'un signal d'horloge de l'accumulateur de phase (106, 116) correspondant en recevant cette valeur binaire de signal d'horloge en entrée non inverseuse, pour éviter d'être trop proche d'un temps de prépositionnement de la bascule synchrone à sortie binaire de poids le plus fort du registre de mémorisation (150) de cet accumulateur de phase (106, 116) correspondant.

6. Dispositif (120 ; 130 ; 140) de synthèse de fréquence selon l'une quelconque des revendications 1 à 5, dans lequel le mécanisme (106A, 116A, 122) de synchronisation de chacun des premier (106) et deuxième (116) accumulateurs de phases comporte en outre une bascule RS (160, 162), dont une sortie délivre un signal (Qrsb) indiquant ledit même instant où les premier (106) et deuxième (116) accumulateurs de phase ont dépassé la valeur seuil, et un mécanisme (164, 166, 168) à bascule synchrone (164) de réinitialisation de cette bascule RS (160, 162) selon un cadencement dépendant d'un signal d'horloge de l'accumulateur de phase (106, 116) correspondant et sous une condition logique (168) de vérification préalable de remise à zéro effective de la sortie binaire de poids le plus fort de la sortie d'un registre de mémorisation (150) de l'accumulateur de phases (106, 116) correspondant.

7. Dispositif (120 ; 130 ; 140) de synthèse de fréquence selon l'une quelconque des revendications 1 à 6, dans lequel chacun des premier (106) et deuxième (116) accumulateurs de phases comporte :

- un additionneur (154) à plusieurs modules d'additions binaires reliés entre eux et dont les sorties sont fournies à des portes logiques OU respectives également toutes alimentées par une sortie de retenue du module d'addition binaire de poids le plus fort de manière à saturer le résultat de l'additionneur (154) sur chacune des sorties binaires des modules d'additions binaires, et

- un registre de mémorisation (150) à bascules synchrones respectivement alimentées par les sorties desdites portes logiques OU et dont les sorties binaires sont fournies en entrées respectives des modules d'additions binaires de l'additionneur (154) pour réaliser la fonction d'accumulation.

**8.** Dispositif (120 ; 130 ; 140) de synthèse de fréquence selon l'une quelconque des revendications 1 à 7, dans lequel la valeur seuil ($T_h$) et la valeur de modulo ($T_h$) sont égales.

**9.** Dispositif (130 ; 140) de synthèse de fréquence selon l'une quelconque des revendications 1 à 8, dans lequel un diviseur de fréquence (132) est disposé dans la boucle de rétroaction (104) entre la sortie et le deuxième accumulateur de phase (116).

**10.** Dispositif (130 ; 140) de synthèse de fréquence selon la revendication 9, dans lequel le diviseur de fréquence (132) présente un facteur de division ($N_d$) choisi de telle sorte que, pour un facteur d'asservissement souhaité de la fréquence de sortie ($F_c$) à la fréquence de référence ($F_{ref}$), le deuxième accumulateur de phase (116) présente une valeur d'incrément de phase qui puisse être aussi proche que possible d'une valeur d'incrément de phase du premier accumulateur de phase (106) tout en restant inférieure ou égale à cette dernière.

**11.** Dispositif (130 ; 140) de synthèse de fréquence selon la revendication 10, dans lequel le facteur de division ($N_d$) est choisi de telle sorte que la partie entière du logarithme de base deux de la valeur d'incrément de phase du premier accumulateur de phase (106) soit égale à la partie entière du logarithme de base deux de la valeur d'incrément de phase du deuxième accumulateur de phase (116).

## Patentansprüche

**1.** Frequenzsynthesevorrichtung (100; 120; 130; 140) mit Rückkopplungsschleife, beinhaltend:

- einen Eingang, bestimmt, um ein elektrisches Signal zu empfangen, das mit einer Referenzfrequenz ($F_{ref}$) oszilliert,
- einen Ausgang, bestimmt, um ein elektrisches Signal bereitzustellen, das mit einer Ausgangsfrequenz ($F_c$) oszilliert,
- eine Schaltung (102) zur Regelung der Ausgangsfrequenz ($F_c$) mit der Referenzfrequenz ($F_{ref}$), die den Eingang mit dem Ausgang der Vorrichtung verbindet und einen ersten Phasenakkumulator (106) beinhaltend, der mit einer Frequenz getaktet ist, die an die Referenzfrequenz ($F_{ref}$) gebunden ist, einen analogen Phasenkomparator (110), einen ersten Digital-/Analog-Wandler (108), der zwischen dem ersten Phasenakkumulator (106) und dem analogen Phasenkomparator (110) angeordnet ist, einen Schleifenfilter (112) und einen Oszillator (114) mit kontrollierter Frequenz, der das elektrische Signal bereitstellt, das mit der Ausgangsfrequenz ($F_c$) oszilliert, und
- eine Rückkopplungsschleife (104), die den Ausgang mit einem der zwei Vergleichseingänge des analogen Phasenkomparators (110) verbindet, einen zweiten Phasenakkumulator (116) beinhaltend, der mit einer Frequenz getaktet ist, die an die Ausgangsfrequenz ($F_c$) gebunden ist, und einen zweiten Digital-Analog-Wandler (118), der zwischen dem zweiten Phasenakkumulator (116) und dem analogen Phasenkomparator (110) angeordnet ist, wobei:
- der erste Digital-/Analog-Wandler (108) beziehungsweise der zweite Digital-/Analog-Wandler (118) angeordnet ist, um am Ausgang ein Signal bereitzustellen, das eine zeitkontinuierliche analoge Darstellung eines digitalen Werts der akkumulierten Phase ($\varphi_{ref}$, $\varphi_c$) ist, die ihm durch den ersten Phasenakkumulator (106) beziehungsweise den zweiten Phasenakkumulator (116) bereitgestellt wird,
- der analoge Phasenkomparator (110) ein zeitkontinuierlicher Addierer oder Subtraktor der zeitkontinuierlichen analogen Signale ist, die ihm am Eingang durch den ersten und zweiten Digital-/Analog-Wandler (108, 118) bereitgestellt werden,
- der erste (106) und zweite (116) Phasenakkumulator einen gemeinsamen Schwellenwert ($T_h$) der akkumulierten Phase aufweisen, jenseits dessen vorgesehen ist, einen Modulowert ($T_h$) vom Wert der akkumulierten Phase in jedem des ersten (106) und zweiten (116) Phasenakkumulators zu subtrahieren, und
- ein Synchronisationsmechanismus (106A, 116A, 122) vorgesehen ist, um den Modulowert ($T_h$) in jedem des ersten (106) und zweiten (116) Phasenakkumulators zu subtrahieren, sobald der gemeinsame Schwellenwert ($T_h$) in jedem des ersten (106) und zweiten (116) Phasenakkumulators überschritten wird,
**dadurch gekennzeichnet, dass** der Synchronisationsmechanismus (106A, 116A, 122) so ausgelegt ist, dass diese Subtraktion des Mo-

dulowerts ($T_h$) zu einem selben Zeitpunkt auf die folgende Weise ausgeführt wird:

- der Synchronisationsmechanismus (106A, 116A, 122) ist so ausgelegt, dass die Subtraktion des Modulowerts ($T_h$) eine asynchrone Rückstellung beinhaltet von zwei jeweiligen synchronen Flipflops mit höchstwertigen binären Ausgängen der zwei jeweiligen Speicherregister (150) des ersten (106) und zweiten (116) Phasenakkumulators, und
- der Synchronisationsmechanismus (106A, 116A, 122) jedes des ersten (106) und zweiten (116) Phasenakkumulators beinhaltend, um die Subtraktion des Modulowerts ($T_h$) zum selben Zeitpunkt auszuführen, ein UND-Logikgatter (152), das den Wert des höchstwertigen binären Ausgangs des synchronen Flipflops des Speicherregisters (150) empfängt, und ein Signal (Qrsb), das den selben Zeitpunkt anzeigt, in dem der erste (106) und der zweite (116) Phasenakkumulator den Schwellenwert überschritten haben, um gegebenenfalls das höchstwertige Bit (Out<3>) des Ausgangs des Speicherregisters (150) zu dem selben Zeitpunkt auf null zu zwingen.

2. Frequenzsynthesevorrichtung (100; 120; 130; 140) nach Anspruch 1, wobei zwischen jedem Phasenakkumulator (106, 116) und jedem jeweiligen Digital-/Analog-Wandler (108, 118) eine Dynamikreduzierung durch Quantisierung vorgesehen ist, wobei diese Quantisierung durch Trunkierung der digitalen Werte der akkumulierten Phasen ausgeführt wird, die auf B Bits am Ausgang jedes Phasenakkumulators (106, 116) codiert sind, auf eine Anzahl von B' Bits von weniger als B.

3. Frequenzsynthesevorrichtung (100; 120; 130; 140) nach Anspruch 2, wobei jede Trunkierung durch Entfernung der niederwertigen Bits B-B' der digitalen Werte der akkumulierten Phasen ausgeführt wird.

4. Frequenzsynthesevorrichtung (100; 120; 130; 140) nach Anspruch 2 oder 3, wobei jede Dynamikreduzierung durch einen Quantifikator mit Delta-Sigma-Modulation (142, 144) ausgeführt wird.

5. Frequenzsynthesevorrichtung (120; 130; 140) nach einem der Ansprüche 1 bis 4, wobei der Synchronisationsmechanismus (106A, 116A, 122) jedes des ersten (106) und zweiten (116) Phasenakkumulators ein UND-Logikgatter (170) beinhaltet, das die asynchrone Rückstellung mit einer zusätzlichen Bedingung steuert, die zu einem binären Wert eines Taktsignals des entsprechenden Phasenakkumulators (106, 116) führt, indem es diesen binären Wert des Taktsignals als nicht invertierenden Eingang empfängt, um zu vermeiden, zu nahe an einer Vorpositionierungszeit des synchronen Flipflops mit höchstwertigem binärem Ausgang des Speicherregisters (150) dieses entsprechenden Phasenakkumulators (106, 116) zu sein.

6. Frequenzsynthesevorrichtung (120; 130; 140) nach einem der Ansprüche 1 bis 5, wobei der Synchronisationsmechanismus (106A, 116A, 122) jedes des ersten (106) und zweiten (116) Phasenakkumulators ferner ein Flipflop RS (160, 162) beinhaltet, von dem ein Ausgang ein Signal (Qrsb) liefert, das den selben Zeitpunkt anzeigt, an dem der erste (106) und zweite (116) Phasenakkumulator den Schwellenwert überschritten haben, und einen Mechanismus (164, 166, 168) mit synchronem Flipflop (164) zur Reinitialisierung dieses Flipflops RS (160, 162) gemäß einer Taktung in Abhängigkeit von einem Taktsignal des entsprechenden Phasenakkumulators (106, 116) und mit einer logischen Bedingung (168) der Vorabprüfung des effektiven Rücksetzens des höchstwertigen binären Ausgangs des Ausgangs eines Speicherregisters (150) des entsprechenden Phasenakkumulators (106, 116).

7. Frequenzsynthesevorrichtung (120; 130; 140) nach einem der Ansprüche 1 bis 6, wobei jeder des ersten (106) und zweiten (116) Phasenakkumulators beinhaltet:

- einen Addierer (154) mit mehreren miteinander verbundenen binären Addiermodulen, an deren Ausgängen jeweilige ODER-Logikgatter bereitgestellt sind, die ebenfalls alle durch einen Übertragungsausgang des höchstwertigen binären Addiermoduls versorgt werden, um so das Ergebnis des Addierers (154) an jedem der binären Ausgänge der binären Addiermodule zu sättigen, und
- ein Speicherregister (150) mit synchronen Flipflops, die jeweils durch die Ausgänge der ODER-Logikgatter versorgt werden und deren binäre Ausgänge in jeweiligen Eingängen der binären Addiermodule des Addierers (154) bereitgestellt werden, um die Akkumulationsfunktion auszuführen.

8. Frequenzsynthesevorrichtung (120; 130; 140) nach einem der Ansprüche 1 bis 7, wobei der Schwellenwert ($T_h$) und der Modulowert ($T_h$) gleich sind.

9. Frequenzsynthesevorrichtung (130; 140) nach einem der Ansprüche 1 bis 8, wobei ein Frequenzteiler (132) in der Rückkopplungsschleife (104) zwischen dem Ausgang und dem zweiten Phasenakkumulator (116) angeordnet ist.

**10.** Frequenzsynthesevorrichtung (130; 140) nach Anspruch 9, wobei der Frequenzteiler (132) einen Divisionsfaktor ($N_d$) aufweist, der so gewählt ist, dass der zweite Phasenakkumulator (116) für einen gewünschten Regelfaktor von der Ausgangsfrequenz ($F_c$) bis zur Referenzfrequenz ($F_{ref}$) einen Phasen-Inkrementierungswert aufweist, der einem Phasen-Inkrementierungswert des ersten Phasenakkumulators (106) so nahe wie möglich sein kann, während er kleiner oder gleich diesem bleibt.

**11.** Frequenzsynthesevorrichtung (130; 140) nach Anspruch 10, wobei der Divisionsfaktor ($N_d$) so gewählt ist, dass der ganzzahlige Teil des Zweierlogarithmus des Phasen-Inkrementierungswerts des ersten Phasenakkumulators (106) gleich dem ganzzahligen Teil des Zweierlogarithmus des Phasen-Inkrementierungswerts des zweiten Phasenakkumulators (116) ist.

**Claims**

**1.** A feedback-loop frequency synthesis device (100; 120; 130; 140) comprising:

- an input intended to receive an electrical signal oscillating at a reference frequency ($F_{ref}$),
- an output intended to provide an electrical signal oscillating at an output frequency ($F_c$),
- a servo circuit (102) for the control of the output frequency ($F_c$) by the reference frequency ($F_{ref}$), connecting the input to the output of the device and comprising a first phase accumulator (106) clocked at a frequency linked to the reference frequency ($F_{ref}$), an analog phase comparator (110), a first digital-to-analog converter (108) arranged between the first phase accumulator (106) and the analog phase comparator (110), a loop filter (112) and a controlled frequency oscillator (114) providing the electrical signal oscillating at the output frequency ($F_c$), and
- a feedback loop (104) connecting the output to one of two comparison inputs of the analog phase comparator (110), comprising a second phase accumulator (116) clocked at a frequency linked to the output frequency ($F_c$) and a second digital-to-analog converter (118) arranged between the second phase accumulator (116) and the analog phase comparator (110),

wherein:

- the first digital-to-analog converter (108), respectively the second digital-to-analog converter (118), is arranged to output a signal that is an analog representation in continuous time of an accumulated phase digital value ($\varphi_{ref}$, $\varphi_c$) supplied to it by the first phase accumulator (106), respectively the second phase accumulator (116),
- the analog phase comparator (110) is a continuous time adder or subtractor of the continuous time analog signals supplied to it as input by the first and second digital-to-analog converters (108, 118),
- the first (106) and second (116) phase accumulators have a common accumulated phase threshold value ($T_h$) above which a modulo value ($T_h$) is to be subtracted from the accumulated phase value in each of the first (106) and second (116) phase accumulators, and
- a synchronization mechanism (106A, 116A, 122) is provided to subtract the modulo value ($T_h$) in each of the first (106) and second (116) phase accumulators as soon as the common threshold value ($T_h$) is exceeded in each of the first (106) and second (116) phase accumulators,

**characterized in that** the synchronization mechanism (106A, 116A, 122) is designed so that this subtraction of the modulo value ($T_h$) is carried out at the same time as follows:

- the synchronization mechanism (106A, 116A, 122) is designed such that the subtraction of the modulo value ($T_h$) comprises an asynchronous resetting of two respective synchronous flip-flops with most significant binary outputs of two respective memory registers (150) of the first (106) and second (116) phase accumulators, and
- the synchronization mechanism (106A, 116A, 122) of each of the first (106) and second (116) phase accumulators comprises, in order to perform the subtraction of the modulo value ($T_h$) at said same instant an AND logic gate (152) receiving the value of the binary output of the most significant synchronous flip-flop of the memory register (150) and a signal ($Qrsb$) indicating the said same instant when the first (106) and second (116) phase accumulators have exceeded the threshold value so as to force the most significant bit (Out<3>) of the output of the memory register (150) to zero at the said same instant, if necessary.

**2.** The frequency synthesis device (100; 120; 130; 140) according to claim 1, wherein a reduction in dynamics by quantization is provided between each phase accumulator (106, 116) and each respective digital-to-analog converter (108, 118), with this quantization being carried out by truncation of digital values of accumulated phases, coded on B bits at the output of each phase accumulator (106, 116), over a number of bits B' less than B.

3. The frequency synthesis device (100; 120; 130; 140) according to claim 2, wherein each truncation is carried out by suppression of the B-B' less significant bits of the digital values of accumulated phases.

4. The frequency synthesis device (100; 120; 130; 140) according to claim 2 or 3, wherein each dynamics reduction is carried out by a Delta-Sigma modulation quantizer (142, 144).

5. The frequency synthesis device (120; 130; 140) according to any one of claims 1 to 4, wherein the mechanism (106A, 116A, 122) for synchronizing each of the first (106) and second (116) phase accumulators comprises an AND logic gate (170) controlling the asynchronous reset under an additional condition relating to the binary value of a clock signal of the corresponding phase accumulator (106, 116) by receiving this binary value of the clock signal as a non-inverting input, in order to avoid being too close to a prepositioning time of the synchronous flip-flop with the most significant binary output of the memory register (150) of this corresponding phase accumulator (106, 116).

6. The frequency synthesis device (120; 130 ; 140) according to any one of claims 1 to 5, wherein the mechanism (106A, 116A, 122) for synchronizing each of the first (106) and second (116) phase accumulators further comprises an RS flip-flop (160, 162), an output of which delivers a signal (Qrsb) indicating said same instant when the first (106) and second (116) phase accumulators have exceeded the threshold value, and a mechanism (164, 166, 168) with synchronous flip-flop (164) for resetting this RS flip-flop (160, 162) according to a timing depending on a clock signal of the corresponding phase accumulator (106, 116) and under a logic condition (168) of prior verification of effective resetting to zero of the most significant binary output of the output of a memory register (150) of the corresponding phase accumulator (106, 116).

7. The frequency synthesis device (120; 130; 140) according to any one of claim 1 to 6, wherein each of the first (106) and second (116) phase accumulators comprises

    - an adder (154) with a plurality of interconnected binary addition modules, the outputs of which are provided to respective OR logic gates also all fed by a carry output of the most significant binary addition module so as to saturate the result of the adder (154) on each of the binary outputs of the binary addition modules, and
    - a memory register (150) with synchronous flip-flops respectively supplied by the outputs of said OR logic gates and whose binary outputs are supplied as respective inputs of the binary addition modules of the adder (154) for performing the accumulation function.

8. The frequency synthesis device (120; 130; 140) according to any one of claim 1 to 7, wherein the threshold value ($T_h$) and the modulo value ($T_h$) are equal.

9. The frequency synthesis device (130; 140) according to any one of claims 1 to 8, wherein a frequency divider (132) is arranged in the feedback loop (104) between the output and the second phase accumulator (116).

10. The frequency synthesis device (130; 140) according to claim 9, wherein the frequency divider (132) has a division factor ($N_d$) chosen in such a way that, for a desired servo factor of control of the output frequency ($F_c$) by the reference frequency ($F_{ref}$), the second phase accumulator (116) has a phase increment value that can be as close as possible to a phase increment value of the first phase accumulator (106) while still remaining less than or equal to the latter.

11. The frequency synthesis device (130; 140) according to claim 10, wherein the division factor ($N_d$) is chosen in such a way that the integer portion of the base two logarithm of the phase increment value of the first phase accumulator (106) is equal to the integer portion of the base two logarithm of the phase increment value of the second phase accumulator (116).

## Figure 1

## Figure 2

## Figure 3

## Figure 4

## Figure 5

## Figure 6

## Figure 7

## Figure 8

## Figure 9

## Figure 10

## Figure 11

## Figure 12

## Figure 13

## Figure 14

## Figure 15

## Figure 16

**EP 3 048 730 B1**

## RÉFÉRENCES CITÉES DANS LA DESCRIPTION

### Documents brevets cités dans la description

- FR 2763196 A1
- US 20110133795 A1
- WO 2009053531 A1
- WO 2004001974 A

### Littérature non-brevet citée dans la description

- **STASZEWSKI et al.** Phase-domain all-digital phase-locked loop. *IEEE Transactions on Circuits and Systems-II,* Mars 2005, vol. 52 (3), 159-163